(19) Europäisches Patentamt / European Patent Office / Office européen des brevets

(11) **EP 3 430 320 B1**

(12) **FASCICULE DE BREVET EUROPEEN**

(45) Date de publication et mention de la délivrance du brevet:
**12.05.2021 Bulletin 2021/19**

(21) Numéro de dépôt: **17716570.1**

(22) Date de dépôt: **20.03.2017**

(51) Int Cl.:
*F24F 11/00* *(2018.01)*

(86) Numéro de dépôt international:
**PCT/FR2017/050650**

(87) Numéro de publication internationale:
**WO 2017/158313 (21.09.2017 Gazette 2017/38)**

(54) **PROCÉDÉ ET DISPOSITIF DE DÉTERMINATION DU TAUX DE RENOUVELLEMENT D'AIR D'UN LOCAL**

VERFAHREN UND VORRICHTUNG ZUR BESTIMMUNG DER LUFTÄNDERUNGSRATE EINES RAUMES ODER GEBÄUDES

METHOD AND DEVICE FOR DETERMINING THE AIR CHANGE RATE OF A ROOM OR BUILDING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.03.2016 FR 1652357**

(43) Date de publication de la demande:
**23.01.2019 Bulletin 2019/04**

(73) Titulaire: **SAINT-GOBAIN ISOVER**
**92400 Courbevoie (FR)**

(72) Inventeurs:
• **ALZETTO, Florent**
  **92300 Levallois Perret (FR)**
• **HEROUT, Benjamin**
  **60500 Chantilly (FR)**

(74) Mandataire: **Saint-Gobain Recherche**
**Département Propriété Industrielle**
**39 Quai Lucien Lefranc**
**93300 Aubervilliers (FR)**

(56) Documents cités:
| | |
|---|---|
| WO-A1-2013/075080 | US-A- 5 267 897 |
| US-A- 5 292 280 | US-A1- 2013 030 575 |

**Description**

La présente invention a trait à un procédé et un dispositif pour déterminer le taux de renouvellement d'air d'un local.

Au sens de l'invention, on entend par "local" tout espace délimité par une enveloppe, en particulier un espace d'habitat ou de stockage. Il peut s'agir d'un espace d'habitat ou de stockage fixe, tel qu'une maison individuelle ou un bâtiment, notamment à usage d'habitation ou tertiaire, une partie d'un tel bâtiment, par exemple un appartement dans un immeuble à plusieurs étages, ou encore une cuve de stockage. Il peut également s'agir d'un espace d'habitat ou de stockage transportable, tel qu'une cabine ou une cuve de stockage dans un véhicule, notamment dans une voiture, un camion, un train, un navire, un sous-marin, un avion, un vaisseau spatial.

Le taux de renouvellement d'air d'un local, noté *ACH,* est le volume d'air intérieur du local qui est renouvelé par heure, exprimé en $m^3.h^{-1}$. Il peut s'agir d'un taux de renouvellement d'air par ventilation naturelle, ou d'un taux de renouvellement d'air par ventilation forcée (c'est-à-dire à l'aide d'une ventilation mécanique contrôlée). Pour un bâtiment ancien à rénover, la détermination du taux de renouvellement d'air par ventilation naturelle, sans ventilation mécanique, est utile pour évaluer si le débit d'air est suffisant en regard de la qualité de l'air intérieur et pour connaître l'impact des infiltrations naturelles sur le bilan énergétique du bâtiment. Pour un bâtiment neuf comprenant un système de ventilation mécanique à récupération de chaleur, on peut déterminer le taux de renouvellement d'air par ventilation naturelle, en configuration désactivée de la ventilation mécanique, ce qui permet d'évaluer l'étanchéité du bâtiment ; on peut également déterminer le taux de renouvellement d'air par ventilation forcée, en configuration active de la ventilation mécanique, ce qui permet d'évaluer le débit du système de ventilation mécanique et de vérifier qu'il fonctionne de manière optimale.

Il est connu de déterminer le taux de renouvellement d'air dans un bâtiment par un test de type "porte soufflante" ("blower door" en anglais), dans lequel on obtient une pressurisation ou une dépressurisation mécanique du bâtiment et on mesure les débits d'air qui en résultent dans une plage de différences de pression statique entre l'intérieur et l'extérieur du bâtiment. Un coefficient classiquement mesuré est le débit de fuite sous 50 Pa divisé par le volume chauffé, noté $n_{50}$, qui correspond au volume d'air renouvelé par heure dans le bâtiment soumis à une différence de pression de 50 Pa entre l'intérieur et l'extérieur du bâtiment.

Dans cette méthode de "porte soufflante", on installe dans une ouverture du bâtiment une fausse porte formée par une bâche étanche dans laquelle est fixé un ventilateur, puis on met en fonctionnement le ventilateur afin de créer une différence de pression entre l'intérieur et l'extérieur du bâtiment, et on procède à des mesurages du débit d'air et de la différence de pression sur une plage de différences de pression allant généralement de 20 Pa à 70 Pa. Ces différences de pression importantes ne permettent pas de rendre compte de l'effet des conditions extérieures sur le bâtiment. Il est nécessaire d'utiliser des modèles physiques pour extrapoler les résultats à de plus faibles différences de pression et remonter à des paramètres physiques réalistes, un exemple étant le modèle de Persily-Kronvall. Toutefois, il est difficile d'obtenir un résultat satisfaisant de manière simple, les modèles physiques simplifiés n'étant pas adaptés à tous les types de bâtiments et les modèles physiques plus élaborés étant complexes à mettre en œuvre. De plus, avec cette méthode, il est nécessaire de réaliser la mesure en condition de faible vent, ce qui n'est pas toujours possible.

Par ailleurs, en physique du bâtiment, il est connu de déterminer le taux de renouvellement d'air par la méthode du gaz traceur, qui a l'avantage de prendre en compte les conditions naturelles de mesure. Dans la variante la plus classique de cette méthode, on injecte une grande quantité d'un gaz spécifique tel que $SF_6$ ou $CO_2$ à l'intérieur du bâtiment, et on mesure la décroissance de la concentration de ce gaz dans l'air pendant plusieurs heures. Le taux de renouvellement d'air est alors estimé par le rapport de la variation temporelle de la concentration du gaz à l'intérieur du bâtiment et de la différence de quantité absolue de celui-ci entre l'intérieur et l'extérieur. Toutefois, cette méthode n'est pas très utilisée sur les chantiers après construction, principalement en raison de son coût et des longues durées de mesure

US 2013/030575 est l'état de la technique le plus proche et divulgue le préambule de la revendication 1.

C'est à ces inconvénients qu'entend plus particulièrement remédier l'invention en proposant un procédé et un dispositif permettant de déterminer le taux de renouvellement d'air d'un local de manière simple et rapide, notamment sur une période de quelques heures, avec un coût modéré et une précision raisonnable, pour tout type de local.

A cet effet, l'invention a pour objet un procédé de détermination du taux de renouvellement d'air *ACH* d'un local, caractérisé en ce qu'il comprend des étapes dans lesquelles :

- sur au moins deux périodes de temps $D_k$ successives correspondant à des débits d'un gaz donné $\dot{q}_k$ distincts appliqués dans le local, on procède à une campagne de mesures permettant de déterminer la concentration du gaz à l'intérieur du local $c_{ik}$ à intervalles de temps rapprochés, ainsi qu'à la détermination de la concentration du gaz à l'extérieur du local $c_{ek}$ à intervalles de temps rapprochés ;
- on détermine la valeur du taux de renouvellement d'air *ACH* du local en faisant converger : d'une part, un modèle diffusif exprimant la variation temporelle de la concentration du gaz à l'intérieur du local $c_{ik}$ en fonction de la concentration du gaz à l'extérieur du local $c_{ek}$ et de paramètres physiques du local à partir desquels le taux de renouvellement d'air *ACH* du local est calculable ; et, d'autre part, l'évolution mesurée $c_{ik}(t)$ de la concentration du gaz à l'intérieur du local en fonction du temps.

Au sens de l'invention, la "concentration du gaz" peut être la teneur en gaz dans l'air en grammes de gaz par mètre cube d'air ($g/m^3$), ce qui correspond à l'humidité absolue dans le cas du gaz $H_2O$, ou la teneur en gaz dans l'air en grammes de gaz par gramme d'air (g/g d'air), ce qui correspond à l'humidité spécifique dans le cas du gaz $H_2O$. Le taux de renouvellement d'air *ACH* du local peut alors être donné soit en $m^3/h$, soit en g d'air/h.

De plus, dans le cadre de l'invention, "l'intérieur du local" et "l'extérieur du local" désignent les deux masses d'air qui sont séparées par l'enveloppe du local et situées respectivement à l'intérieur et à l'extérieur de l'enveloppe du local.

Le gaz utilisé dans le cadre de l'invention, dont on applique des débits distincts $\dot{q}_k$ dans le local et dont on suit l'évolution de la concentration, peut être choisi, notamment, parmi $H_2O$, $CO_2$, He, $SF_6$, $H_2$, $N_2$, ou d'autres gaz traceurs réfrigérants, cette liste n'étant pas limitative. Plusieurs critères importants sont à considérer pour le choix du gaz, en particulier le gaz doit être facilement identifiable et mesurable dans l'atmosphère ; le gaz ne doit pas être dangereux lors d'une inhalation longue ou fréquente, même si le procédé ne requiert pas la présence de personnes tout au long des mesures ; de préférence, le gaz n'est pas nocif pour l'environnement. De plus, l'utilisation d'un gaz qui est présent dans l'atmosphère, tel que $H_2O$ ou $CO_2$, impose la prise en compte de la concentration de celui-ci dans l'atmosphère et l'utilisation de rectifications lors du calcul du taux de renouvellement d'air. L'utilisation de la vapeur d'eau $H_2O$ dans le cadre de l'invention, en tant que gaz dont on applique des débits distincts $\dot{q}_k$ dans le local et dont on suit l'évolution de la concentration, est avantageuse du fait de son faible coût, de son innocuité et de la facilité à générer un débit de vapeur d'eau.

L'invention permet une détermination in situ du taux de renouvellement d'air d'un local. Le principe à la base de l'invention est d'utiliser les variations transitoires de la concentration d'un gaz donné à l'intérieur du local lorsque le local est soumis à des sollicitations internes contrôlées et dans un environnement externe mesuré. L'analyse quantitative de la variation de la concentration du gaz à l'intérieur du local permet de déterminer quantitativement le renouvellement d'air entre l'intérieur et l'extérieur du local sur une période courte, de l'ordre de quelques heures, en limitant le nombre de paramètres susceptibles d'influencer le comportement du local. En particulier, la brièveté des mesures permet de s'affranchir de l'influence des conditions d'utilisation du local, des variations des conditions extérieures et des phénomènes d'absorption ou de désorption du gaz par les matériaux de construction et/ou le mobilier du local.

Dans le cadre de l'invention, on entend par "débit du gaz appliqué dans le local" toute condition opératoire générant une variation de la concentration du gaz à l'intérieur du local, pour des conditions données de concentration du gaz à l'extérieur du local. Il est entendu que le débit du gaz appliqué dans le local peut être positif, nul ou négatif. Un débit du gaz positif correspond à une injection du gaz dans le local, alors qu'un débit du gaz négatif correspond à une extraction du gaz hors du local. Dans le cas d'un débit du gaz nul ou sensiblement nul appliqué dans le local, la variation de la concentration du gaz à l'intérieur du local peut résulter d'un déséquilibre entre les concentrations initiales du gaz à l'intérieur et à l'extérieur du local. Selon l'invention, il est prévu qu'au moins l'un des débits dudit gaz donné $\dot{q}_k$ est non nul.

Dans le cadre de l'invention, on détermine la valeur du taux de renouvellement d'air *ACH* du local en faisant converger un modèle diffusif et l'évolution mesurée $c_{ik}(t)$ de la concentration du gaz à l'intérieur du local en fonction du temps. Dans un mode de réalisation avantageux, le modèle diffusif exprime la variation temporelle de la concentration du gaz à l'intérieur du local $c_{ik}$ en fonction de la concentration du gaz à l'extérieur du local $c_{ek}$ et du débit du gaz dans le local $\dot{q}_k$. Lorsque la variation temporelle de $c_{ik}$ est exprimée en fonction de $c_{ek}$ seulement, il est possible d'accéder à une évaluation de $\dfrac{ACH}{V}$, avec *V* le volume effectif du local, c'est-à-dire qu'on accède à un nombre de volume renouvelé par heure.

Le modèle diffusif utilisé pour déterminer le taux de renouvellement d'air du local peut être de tout type connu de l'homme du métier.

Selon un aspect de l'invention, le modèle diffusif utilisé pour déterminer le taux de renouvellement d'air du local peut être un modèle R-C avec un nombre adapté de résistances et de capacités. De préférence, le modèle diffusif est un modèle R-C simple avec une résistance et une capacité. En variante, le modèle diffusif peut être, notamment, un modèle R-C plus complexe que le modèle R-C simple tel qu'un modèle dit "3R2C" avec trois résistances et deux capacités.

Selon un autre aspect de l'invention, le modèle diffusif utilisé pour déterminer le taux de renouvellement d'air du local peut être un modèle d'identification paramétrique (ou modèle d'identification de système), c'est-à-dire dans lequel un modèle mathématique d'un système est obtenu à partir de mesures, tel que les modèles décrits dans l'ouvrage « Time Series Analysis » de Henrik Madsen, Chapman & Hall, 2008 (ISBN-13:978-1420059670 0).

En particulier, le modèle diffusif utilisé pour déterminer le taux de renouvellement d'air du local peut être un modèle autorégressif, notamment un modèle ARX (Auto Régressive model with eXternal inputs). En variante, d'autres modèles autorégressifs peuvent être utilisés comme par exemple des modèles ARMAX.

De façon connue, un modèle ARX est un modèle autorégressif définissant une sortie y(t) en fonction d'une ou de plusieurs entrées u(t), v(t) et d'un résidu aléatoire de modélisation caractérisé par un bruit blanc de moyenne nulle e(t), t désignant l'instant d'échantillonnage considéré. Le modèle ARX, en prenant en compte le retard, s'écrit :

$$A(p^{-1})y_k = B(p^{-1})u_k + D(p^{-1})v_k + e_k$$

avec :

$$A(p^{-1}) = 1 + a_1 p^{-1} + \cdots + a_n p^{-n}$$

$$B(p^{-1}) = b_1 p^{-1} + \cdots + b_n p^{-n}$$

$$D(p^{-1}) = d_1 p^{-1} + \cdots + d_n p^{-n}$$

et :

$$p^{-1}u_k = u_{k-1}$$

$$p^{-1}v_k = v_{k-1}$$

$p^{-1}$ est appelé opérateur de retard et prend en compte les états passés influençant le système au temps présent. $n$ est l'ordre du modèle ARX. Concernant le choix de l'ordre $n$ du modèle ARX, la valeur de $n$ doit être suffisamment élevée pour prendre en compte l'inertie du système, mais suffisamment faible pour éviter un sur-paramétrage du modèle.

Les étapes d'identification d'un modèle sont connues en soi et ne sont donc pas détaillées plus avant ici. Les coefficients à identifier par ajustement (fitting) du modèle ARX sur l'évolution mesurée $c_{ik}(t)$ sont les coefficients $a_i$, $b_i$, $d_i$, $i$ = 1, ..., $n$, auxquels est relié le taux de renouvellement d'air *ACH* du local.

En particulier, dans le cas de la modélisation de la diffusion d'un gaz dans un local, on peut considérer que la sortie y(t) du modèle ARX est la concentration du gaz à l'intérieur du local $c_{ik}$ et les entrées u(t) et v(t) du modèle ARX sont, respectivement, la concentration du gaz à l'extérieur du local $c_{ek}$ et le débit du gaz dans le local $\dot{q}_k$. Pour l'identification, on procède par analogie entre l'état statique du modèle ARX ($p^{-1}$ = 1) :

$$A(1)c_{ik} = B(1)c_{ek} + D(1)\dot{q}_k + e$$

et le bilan de matière physique :

$$\dot{q}_k = ACH(c_{ek} - c_{ik}) + e$$

Les paramètres physiques sont alors obtenus simplement par comparaison entre les deux équations précédentes. En particulier, par un traitement mathématique classique et accessible dans la littérature scientifique, on obtient le taux de renouvellement d'air *ACH* du local comme étant une moyenne pondérée des $\frac{\sum_{i=1}^{n} ai}{\sum_{i=1}^{n} di}$ et des $\frac{\sum_{i=1}^{n} bi}{\sum_{i=1}^{n} di}$.

On note que les entrées et sorties d'un modèle d'identification paramétrique peuvent être interverties. En particulier dans le cadre de l'invention, pour le traitement des données de mesures $c_{ik}(t)$ avec un modèle ARX, il est possible de considérer que la sortie y(t) du modèle ARX est le débit du gaz dans le local $\dot{q}_k$ et les entrées u(t) et v(t) du modèle ARX sont, respectivement, la concentration du gaz à l'extérieur du local $c_{ek}$ et la concentration du gaz à l'intérieur du local $c_{ik}$.

Au sens de l'invention, le fait de faire converger le modèle diffusif et l'évolution mesurée $c_{ik}(t)$ signifie que l'on ajuste la valeur de paramètres physiques du local utilisés dans le modèle diffusif de manière à minimiser l'écart, au moins sur un intervalle de temps compris dans chaque période de temps $D_k$, entre l'évolution temporelle de la concentration du gaz à l'intérieur du local calculée à partir du modèle diffusif et l'évolution temporelle de la concentration du gaz à l'intérieur du local effectivement mesurée $c_{ik}(t)$. L'ajustement peut ainsi se faire sur toute l'étendue de chaque période de temps $D_k$, ou sur un ou plusieurs intervalles de temps compris dans chaque période de temps $D_k$.

A titre d'exemple, dans le cas où le modèle diffusif est un modèle R-C simple avec une résistance et une capacité et où, pour chaque période de temps $D_k$, il existe un intervalle de temps $\Delta t_k$ pour lequel l'évolution mesurée $c_{ik}(t)$ de la concentration du gaz à l'intérieur du local en fonction du temps est sensiblement linéaire, on peut faire converger le modèle R-C simple et l'évolution mesurée $c_{ik}(t)$ sur les intervalles de temps $\Delta t_k$ de la manière suivante : pour chaque période de temps $D_k$ on détermine sur l'intervalle de temps $\Delta t_k$ la pente $a_k$ de la tangente à l'évolution $c_{ik}(t)$ et on déduit la valeur du taux de renouvellement d'air $ACH$ du local à partir des pentes $a_k$, des débits du gaz $\dot{q}_k$ appliqués dans le local et de la différence de concentration du gaz entre l'intérieur et l'extérieur du local.

Selon un autre exemple, dans le cas où le modèle diffusif est un modèle R-C plus complexe, tel qu'un modèle "3R2C", ou un modèle ARX, on fait converger le modèle diffusif et l'évolution mesurée $c_{ik}(t)$ en ajustant la valeur des paramètres physiques du local utilisés dans le modèle de manière à minimiser l'écart ("fitting"), sur l'ensemble des périodes de temps $D_k$, entre l'évolution temporelle de la concentration du gaz à l'intérieur du local calculée à partir du modèle diffusif et l'évolution temporelle de la concentration du gaz à l'intérieur du local effectivement mesurée $c_{ik}(t)$.

Des exemples de paramètres du local susceptibles d'influencer le comportement du local pour la diffusion de gaz comprennent, notamment, la surface totale d'enveloppe du local, le nombre et la taille des menuiseries, permettant par exemple de déterminer une surface équivalente de trous.

Selon un aspect de l'invention, le procédé comprend des étapes dans lesquelles :

- sur au moins deux périodes de temps $D_k$ successives correspondant à des débits du gaz $\dot{q}_k$ distincts appliqués dans le local, on procède à une campagne de mesures permettant de déterminer la concentration du gaz à l'intérieur du local $c_{ik}$ à intervalles de temps rapprochés, ainsi qu'à la détermination de la concentration du gaz à l'extérieur du local $c_{ek}$ à intervalles de temps rapprochés ;
- pour chaque période de temps $D_k$, à partir de l'évolution mesurée $c_{ik}(t)$ de la concentration du gaz à l'intérieur du local $c_{ik}$ en fonction du temps :

  o soit, s'il existe un intervalle de temps $\Delta t_k$ pour lequel l'évolution $c_{ik}(t)$ est sensiblement linéaire, on détermine sur cet intervalle de temps $\Delta t_k$ la pente $a_k$ de la tangente à l'évolution $c_{ik}(t)$ et on déduit la valeur du taux de renouvellement d'air ACH du local à partir des pentes $a_k$ ;
  o soit, s'il n'existe pas d'intervalle de temps pour lequel l'évolution $c_{ik}(t)$ est sensiblement linéaire, on sélectionne un intervalle de temps $\Delta t_k'$ sur lequel l'évolution $c_{ik}(t)$ est sensiblement exponentielle de type $\exp(-t/\tau)$, avec $\tau$ le temps au bout duquel le volume d'air intérieur du local a été renouvelé, et on déduit la valeur du taux de renouvellement d'air $ACH$ du local, qui est la valeur telle que l'évolution

$$ Ln\left[\left(\theta_k(t) - \frac{\dot{q}_k}{ACH}\right) / \left(\theta_k(0) - \frac{\dot{q}_k}{ACH}\right)\right] $$ est une droite, avec $\theta_k(t) = c_{ik}(t) - c_{ekm}'$ où $c_{ekm}'$ est la moyenne de la concentration du gaz à l'extérieur du local $c_{ek}$ sur l'intervalle de temps $\Delta t_k'$.

Bien entendu, le procédé selon l'invention ne requiert pas nécessairement la mise en place d'une représentation graphique de l'évolution $c_{ik}(t)$.

En particulier, sur chaque intervalle de temps $\Delta t_k$, la pente $a_k$ de la tangente à l'évolution $c_{ik}(t)$ est égale à la dérivée de l'évolution $c_{ik}(t)$ sur l'intervalle $\Delta t_k$. Dès lors, l'étape de détermination de la pente $a_k$ de la tangente à l'évolution $c_{ik}(t)$ sur l'intervalle $\Delta t_k$ peut être réalisée, dans le cadre de l'invention, en calculant la dérivée de l'évolution $c_{ik}(t)$ sur l'intervalle $\Delta t_k$, sans recourir à une représentation graphique de l'évolution $c_{ik}(t)$.

Les étapes de calcul du procédé, en particulier pour la détermination des pentes $a_k$, peuvent être mises en œuvre à l'aide de tout moyen de calcul approprié. Il peut s'agir notamment d'un terminal comportant un système d'acquisition pour acquérir les mesures requises par le procédé et des moyens de calcul pour exécuter tout ou partie des étapes du procédé à partir des mesures acquises.

Dans le cadre de l'invention, les périodes de temps $D_k$ peuvent être soit disjointes, soit immédiatement successives les unes aux autres. Dans ce dernier cas, on peut considérer que le procédé est réalisé dans sa globalité sur une période de temps continue, formée par la succession des périodes de temps $D_k$.

De préférence, le procédé est mis en œuvre avec deux périodes de temps $D_1$ et $D_2$ successives correspondant à deux consignes de débits du gaz $\dot{q}_1$ et $\dot{q}_2$ distinctes appliquées dans le local.

Selon un aspect de l'invention, le premier débit du gaz $\dot{q}_1$ appliqué sur la première période de temps $D_1$ et le deuxième débit du gaz $\dot{q}_2$ appliqué sur la deuxième période de temps $D_2$ ont des valeurs éloignées l'une de l'autre.

Dans un mode de réalisation avantageux, le premier débit du gaz $\dot{q}_1$ appliqué sur la première période de temps $D_1$ est strictement positif ou strictement négatif, alors que le deuxième débit du gaz $\dot{q}_2$ appliqué sur la deuxième période de temps $D_2$ est nul ou sensiblement nul.

De manière avantageuse, pour chaque période de temps $D_k$, le débit du gaz $\dot{q}_k$ appliqué dans le local comprend un débit $\dot{q}_{impk}$ imposé au moyen d'au moins un appareil à débit contrôlé. On entend ici par "appareil à débit contrôlé" un appareil tel que la quantité du gaz injectée ou extraite par l'appareil peut être déterminée précisément. De préférence, la commande du ou de chaque appareil à débit contrôlé est automatisée.

Lorsque le gaz utilisé est la vapeur d'eau, le ou chaque appareil à débit contrôlé peut être un humidificateur, par exemple un humidificateur à ultrasons. Une méthode pour déterminer précisément le débit de vapeur d'eau injecté sur chaque période de temps $D_k$ est alors de peser l'humidificateur au début et à la fin de la période $D_k$ et, connaissant la durée d'allumage de l'humidificateur, de déduire le débit moyen de vapeur d'eau appliqué dans le local sur la période $D_k$.

Dans le cadre de l'invention, les débits du gaz $\dot{q}_k$ distincts appliqués dans le local sur les différentes périodes de temps $D_k$ peuvent être différentes consignes de débit du gaz, c'est-à-dire que pour chaque période de temps $D_k$ le débit du gaz $\dot{q}_k$ est constant sur toute la période $D_k$. En variante, le débit du gaz $\dot{q}_k$ peut ne pas être constant sur une ou plusieurs périodes $D_k$ et varier autour d'une valeur de débit du gaz moyen $\dot{q}_{km}$, pour autant que le débit du gaz moyen $\dot{q}_{km}$ sur la période $D_k$ soit distinct des débits du gaz (constants ou moyens) appliqués sur les périodes de temps qui entourent la période $D_k$. Dans ce cas, le débit du gaz considéré sur la période de temps $D_k$ est le débit du gaz moyen $\dot{q}_{km}$. La variation du débit du gaz sur chaque période de temps $D_k$ doit être faible par rapport à la différence entre les débits du gaz appliqués sur deux périodes de temps consécutives, de préférence la variation du débit du gaz sur chaque période de temps $D_k$ est inférieure à 30%, encore de préférence inférieure à 20%, encore de préférence inférieure à 10%, de la différence entre les débits du gaz appliqués sur deux périodes de temps consécutives.

Si aucune source du gaz donné autre que les appareils utilisés pour appliquer le débit imposé $\dot{q}_{impk}$ n'est active dans le local au cours de la période de temps $D_k$, le débit du gaz $\dot{q}_k$ appliqué dans le local est égal au débit imposé $\dot{q}_{impk}$. En revanche s'il existe, au cours de la période de temps $D_k$, un débit du gaz supplémentaire $\dot{q}_{supk}$ appliqué dans le local en plus du débit $\dot{q}_{impk}$, le débit du gaz $\dot{q}_k$ appliqué dans le local est égal à $\dot{q}_{impk} + \dot{q}_{supk}$. Il convient donc, soit d'être capable de mesurer le débit supplémentaire, soit de couper toutes les sources autres que les appareils utilisés pour appliquer le débit imposé.

En particulier, lorsque le gaz utilisé est la vapeur d'eau, un débit de vapeur d'eau supplémentaire dans le local peut provenir de sources telles que la respiration des occupants, la cuisson, la présence de linge qui sèche, l'utilisation d'une douche, l'utilisation d'un sèche-linge. De préférence, le procédé est mis en œuvre alors que le local est inoccupé. De plus, les éventuels appareils électroménagers sont préférentiellement éteints.

Le procédé selon l'invention repose sur le fait que la variation de la concentration du gaz à l'intérieur du local est proportionnelle à la quantité d'air renouvelée par les infiltrations. Si la concentration du gaz à l'intérieur du local n'est pas homogène, il existe un risque qu'une quantité plus importante d'air que du gaz soit échangée, ou vice-versa, ce qui est susceptible de rendre les mesures imprécises. Le même risque peut résulter de stratifications du gaz, causées par des écarts trop importants de température à l'intérieur du local. Afin d'améliorer l'homogénéité de la concentration du gaz et de la température à l'intérieur du local, il est avantageux d'ouvrir les portes de communication à l'intérieur du local et de mettre en place un système de brassage de l'air à l'intérieur du local. Lorsque le local présente un grand volume intérieur, plusieurs appareils à débit contrôlé sont avantageusement répartis dans le local, en étant associés à un système de brassage de l'air.

Selon un aspect de l'invention, les mesures permettant de déterminer la concentration du gaz à l'intérieur du local $c_{ik}$ sont effectuées à l'aide d'un ou de plusieurs capteurs dudit gaz placés dans le volume d'air à l'intérieur du local. Dans le cas où le gaz utilisé est la vapeur d'eau, chaque capteur dudit gaz est un capteur d'humidité configuré pour mesurer la concentration de vapeur d'eau, également appelée humidité absolue, à l'intérieur du local $c_{ik}$.

De préférence, chaque capteur dudit gaz est associé à un capteur de température apte à mesurer la température de l'air à l'intérieur du local. La concentration du gaz à l'intérieur du local $c_{ik}$, et la température à l'intérieur du local $T_{ik}$, peuvent alors être considérées chacune comme étant la moyenne des mesures des différents capteurs distribués dans le volume d'air à l'intérieur du local. Le nombre de capteurs doit être d'autant plus important que l'homogénéité de la concentration du gaz et de la température à l'intérieur du local est imparfaite. L'utilisation de plusieurs capteurs dans différents endroits peut également permettre de localiser les fuites d'air, par exemple en repérant qu'un capteur positionné près d'une menuiserie peu étanche a un comportement différent d'un capteur positionné au centre du volume d'air à l'intérieur du local.

De préférence, sur chaque période de temps $D_k$, la température de l'air à l'intérieur du local $T_{ik}$ est stable. Des variations de la température de l'air à l'intérieur du local peuvent en effet influer sur la concentration du gaz dans l'air à l'intérieur du local. Dès lors, il est préférable, sur chaque période de temps $D_k$, de couper ou de maintenir à une consigne constante les sources de chaleur ou de froid dans le local, notamment les dispositifs de chauffage ou de climatisation. En particulier, lorsque le gaz utilisé est la vapeur d'eau, une augmentation de la température à l'intérieur du local peut entraîner un séchage des matériaux dans le local, d'où une évaporation de vapeur d'eau dans l'air, tandis qu'une diminution de la température à l'intérieur du local peut entraîner une condensation de vapeur d'eau présente dans l'air à la surface des matériaux.

Il est également préférable, sur chaque période de temps $D_k$, d'avoir un rayonnement solaire faible, de préférence nul, afin d'éviter une augmentation de la température à l'intérieur du local sous l'effet du rayonnement solaire. Les volets ou autres éléments occultants du local peuvent être fermés au cours de chaque période de temps $D_k$, notamment du côté du local orienté vers le sud. De préférence, le procédé selon l'invention est mis en œuvre de nuit.

Selon un aspect avantageux, en vue de limiter le temps de mise en œuvre du procédé tout en réduisant la contribution du rayonnement solaire, le procédé est réalisé dans sa globalité en continu sur une seule période nocturne.

Pour que l'évolution de l'humidité absolue à l'intérieur du local lors de la mise en œuvre du procédé soit uniquement liée au renouvellement d'air, il faut se placer dans des conditions telles que les échanges de vapeur d'eau contenue dans l'air et dans les matériaux de construction et/ou le mobilier sont négligeables. Or, à titre d'exemple, une surface de 50 m$^2$ de chêne non vernis peut stocker environ 2 kg d'eau en 3 heures lorsque l'humidité à l'intérieur du local varie de 60% à 80%. Il est donc favorable d'appliquer les débits de vapeur d'eau distincts et d'effectuer les mesures conformément à l'invention sur des périodes de temps $D_k$ aussi courtes que possible, afin de limiter ces échanges. De préférence, chaque période de temps $D_k$ a une durée inférieure ou égale à 2 heures, plus préférentiellement inférieure ou égale à 1 heure.

Si l'on souhaite mesurer le taux de renouvellement d'air par infiltration naturelle d'un local équipé d'un système de ventilation mécanique, la ventilation mécanique doit être désactivée sur chaque période de temps $D_k$, afin de ne pas introduire un débit d'air additionnel. En variante, il est possible de maintenir la ventilation mécanique en configuration active à un débit souhaité sur les périodes de temps $D_k$, le procédé selon l'invention permettant alors de mesurer le débit d'air engendré par la ventilation mécanique et ainsi de vérifier son fonctionnement.

De préférence, sur chaque période de temps $D_k$, la concentration du gaz à l'extérieur du local $c_{ek}$ est stable.

La concentration du gaz à l'extérieur du local $c_{ek}$ peut être déterminée par des mesures à l'aide de capteurs dudit gaz placés dans l'air à l'extérieur du local, notamment des capteurs d'humidité et de température lorsque le gaz utilisé est la vapeur d'eau. Ces capteurs d'humidité et de température sont placés dans le volume d'air extérieur en évitant d'être à proximité de sources de chaleur ou de production de vapeur d'eau, afin d'avoir des mesures représentatives de la masse d'air globale au voisinage de la surface extérieure de l'enveloppe du local.

En variante, lorsque le gaz utilisé est la vapeur d'eau et le local donne directement à l'extérieur, la concentration de vapeur d'eau ou humidité absolue à l'extérieur du local $c_{ek}$ peut être déterminée par interpolation de données météorologiques du lieu du local.

En général, l'air extérieur contient de la vapeur d'eau, surtout en période humide. Le procédé selon l'invention est d'autant plus fiable que les débits de vapeur d'eau appliqués dans le local conformément au procédé de l'invention sont adaptés aux conditions extérieures et que la différence d'humidité absolue entre l'intérieur et l'extérieur du local est grande.

Dans le cadre de l'invention, on peut utiliser un modèle R-C simple pour décrire un local, avec deux nœuds de concentration du gaz homogène (en g.m$^{-3}$), l'un à l'intérieur du local et l'autre à l'extérieur du local, qui sont séparés par une résistance représentant l'inverse du taux de renouvellement d'air $ACH$ du local (en m$^3$.h$^{-1}$). Le nœud de concentration du gaz à l'intérieur du local est relié à un condensateur qui représente le volume effectif du local (en m$^3$). Le débit du gaz appliqué dans le local (en g.h$^{-1}$) est compensé par l'échange du gaz à travers l'enveloppe du local et la quantité du gaz emmagasinée dans la structure de l'enveloppe, ce qui est décrit par l'équation :

$$\dot{q}_k = ACH(c_{ik} - c_{ek}) + V\frac{dc_{ik}}{dt}$$

où $\dot{q}_k$ est débit du gaz total appliqué dans le local, $c_{ik}$ et $c_{ek}$ sont respectivement la concentration du gaz à l'intérieur du local et la concentration du gaz à l'extérieur du local, $ACH$ est le taux de renouvellement d'air du local et $V$ est le volume effectif du local.

On suppose que la réponse du local est une simple exponentielle décroissante et que sa constante de temps est le produit du taux de renouvellement d'air $ACH$ et du volume effectif $V$ du local. En réalité, la réponse du local est plus complexe et est la superposition d'un grand nombre d'exponentielles décroissantes, mais il a été validé expérimentalement qu'en adaptant les conditions du test, en particulier la durée du test et la valeur de débit de gaz appliqué dans le local, seule la constante de temps la plus grande joue un rôle et le modèle décrit précédemment est valide.

En appliquant deux débits du gaz $\dot{q}_1$ et $\dot{q}_2$ de valeurs différentes dans le local sur deux périodes de temps $D_1$ et $D_2$, il est alors possible de déterminer le taux de renouvellement d'air $ACH$ du local selon l'équation :

$$ACH = \frac{a_1 \times \dot{q}_2 - a_2 \times \dot{q}_1}{a_1 \times \Delta c_{2m} - a_2 \times \Delta c_{1m}} \quad (1)$$

et le volume effectif $V$ du local selon l'équation :

$$V = \frac{\dot{q}_1 \times \Delta c_{2m} - \dot{q}_2 \times \Delta c_{1m}}{a_1 \times \Delta c_{2m} - a_2 \times \Delta c_{1m}} \quad (2)$$

où $(\dot{q}_k)_{k=1 \text{ ou } 2}$ est le débit du gaz appliqué sur la période de temps $D_k$, $(a_k)_{k=1 \text{ ou } 2}$ est la pente sur l'intervalle de temps $\Delta t_k$ de la tangente à l'évolution $c_{ik}(t)$ de la concentration du gaz à l'intérieur du local en fonction du temps, et $(\Delta c_{km})_{k=1 \text{ ou } 2}$ est la différence entre la concentration du gaz moyenne à l'intérieur du local et la concentration du gaz moyenne à l'extérieur du local sur l'intervalle de temps $\Delta t_k$.

Selon un aspect de l'invention, suite à la détermination de la valeur calculée $V_{calc}$ du volume effectif $V$ du local conformément au procédé, on vérifie que cette valeur $V_{calc}$ correspond bien au volume réel du local, notamment à 20% près. Si ce n'est pas le cas, il est nécessaire de modifier le traitement des mesures pour obtenir une valeur corrigée du taux de renouvellement d'air $ACH$ du local.

En effet, il a été constaté que le procédé selon l'invention peut conduire à une valeur calculée $V_{calc}$ du volume effectif du local différente du volume réel du local. En particulier, lorsque le gaz utilisé est de la vapeur d'eau injectée dans le local, il a été observé que, quand la durée de chaque période de temps $D_k$ est trop courte, la valeur calculée $V_{calc}$ est plus faible que le volume réel, alors que quand la durée de chaque période de temps $D_k$ est trop longue, la valeur calculée $V_{calc}$ est plus importante que le volume réel. Cela peut s'expliquer par le fait que la valeur calculée $V_{calc}$ du volume effectif $V$ du local ne correspond pas au volume réel du local, mais plutôt au volume effectivement sollicité par le gaz utilisé dans le cadre du procédé. Une valeur calculée $V_{calc}$ sous-estimée par rapport au volume réel du local peut indiquer que le gaz n'a pas eu le temps de sonder tout le volume du local, tandis qu'une valeur calculée $V_{calc}$ surestimée par rapport au volume réel du local peut indiquer un effet lié à l'absorption du gaz par les matériaux présents dans le local.

Il convient alors, pour le traitement des mesures obtenues selon le procédé de l'invention, de se placer à des durées suffisamment longues pour le que gaz ait sollicité tout le volume du local, mais suffisamment courtes pour éviter tout effet lié à l'absorption du gaz par les matériaux de construction et/ou le mobilier du local, et ainsi ne mesurer que le renouvellement d'air responsable de la variation de la concentration du gaz dans l'air. Dans le cas où le gaz utilisé est de la vapeur d'eau injectée dans le local, il a été constaté qu'une durée favorable pour le traitement des mesures sur chaque période de temps $D_k$ est de l'ordre de 10 minutes à 1 heure.

De manière très avantageuse, la comparaison de la valeur calculée $V_{calc}$ du volume effectif du local par rapport au volume réel permet ainsi de valider si le taux de renouvellement d'air $ACH$ du local a été déterminé correctement, d'aider à définir des durée favorables pour le traitement des mesures sur chaque période de temps $D_k$ en fonction des matériaux présents dans le local, et même de corriger a posteriori la valeur calculée $ACH_{calc}$ du taux de renouvellement d'air du local dans le cas où une durée trop longue a été appliquée pour le traitement des mesures. En particulier, on peut procéder à une telle correction a posteriori de la valeur $ACH_{calc}$ en déplaçant les intervalles de temps $\Delta t_k$ dans chaque période de temps $D_k$, de manière à réduire la durée de traitement des mesures, jusqu'à obtenir une valeur du volume effectif $V_{calc}$ sensiblement égale au volume intérieur réel du local.

Selon un mode de réalisation, le procédé comprend des étapes dans lesquelles :

- on procède, sur deux périodes de temps $D_1$ et $D_2$ successives :

  i. sur la première période de temps $D_1$, à l'application dans le local d'un premier débit du gaz $\dot{q}_1$, et à une campagne de mesures permettant de déterminer la concentration du gaz à l'intérieur du local $c_{i1}$ à intervalles de temps rapprochés, ainsi qu'à la détermination de la concentration du gaz à l'extérieur du local $c_{e1}$ à intervalles de temps rapprochés, le premier débit du gaz $\dot{q}_1$ étant tel que le paramètre $\alpha = 1 - \frac{ACH_{ref}.\Delta c_1(0)}{\dot{q}_1}$ est inférieur ou égal à 0,8, avec $\Delta c_1(0) = c_{i1}(0) - c_{em}$, où $t = 0$ est le point de départ de la première période de temps $D_1$, $c_{em}$ est la concentration moyenne du gaz à l'extérieur du local sur l'ensemble des périodes de temps $D_1$ et $D_2$, et $ACH_{ref}$ est une valeur de référence du taux de renouvellement d'air du local, puis
  
  ii. sur la deuxième période de temps $D_2$, à l'application dans le local d'un deuxième débit du gaz $\dot{q}_2$ sensiblement nul, et à une campagne de mesures permettant de déterminer la concentration du gaz à l'intérieur du local $c_{i2}$

à intervalles de temps rapprochés, ainsi qu'à la détermination de la concentration du gaz à l'extérieur du local $c_{e2}$ à intervalles de temps rapprochés ;

- on détermine la valeur du taux de renouvellement d'air $ACH$ du local en faisant converger : d'une part, un modèle diffusif exprimant la variation temporelle de la concentration du gaz à l'intérieur du local $c_{ik}$ en fonction de la concentration du gaz à l'extérieur du local $c_{ek}$ et de paramètres physiques du local à partir desquels le taux de renouvellement d'air $ACH$ du local est calculable ; et, d'autre part, l'évolution mesurée $c_{ik}(t)$ de la concentration du gaz à l'intérieur du local $c_{ik}$ en fonction du temps.

Dans ce mode de réalisation, on sélectionne une sollicitation spécifique du local, qui permet d'accéder au taux de renouvellement d'air $ACH$ du local avec une bonne précision et sur un temps réduit, cette sollicitation spécifique étant l'application d'un premier débit du gaz $\dot{q}_1$ strictement positif ou strictement négatif propre à générer une évolution forcée de la concentration du gaz à l'intérieur du local $c_{i1}$, suivie de l'application d'un deuxième débit du gaz $\dot{q}_2$ sensiblement nul donnant lieu à une évolution libre de la concentration du gaz à l'intérieur du local $c_{i1}$.

$$\alpha = 1 - \frac{ACH_{ref}.\Delta c_1(0)}{\dot{q}_1}$$

De préférence, le premier débit du gaz $\dot{q}_1$ est tel que le paramètre        est supérieur ou égal à 0,3, de préférence supérieur ou égal à 0,4. En effet, pour des milieux présentant peu d'infiltrations, lorsque le paramètre $\alpha$ est inférieur à 0,3 ou 0,4, la sensibilité des capteurs de mesure classiques ne permet pas d'obtenir des données satisfaisantes concernant l'évolution de la concentration du gaz à l'intérieur du local $c_{i1}$ sur la première période de temps $D_1$, d'où une augmentation de l'incertitude sur la valeur du taux de renouvellement d'air $ACH$ du local déterminé selon l'invention.

La détermination de la valeur du premier débit du gaz $\dot{q}_1$ à appliquer sur la première période de temps $D_1$ pour satisfaire aux critères sur le paramètre $\alpha$ impose de connaître une valeur de référence $ACH_{ref}$ du taux de renouvellement d'air $ACH$ du local.

Une méthode pour accéder à une valeur de référence $ACH_{ref}$ du taux de renouvellement d'air $ACH$ du local est l'utilisation d'une grandeur issue d'un test de type "porte soufflante" du local. D'autres méthodes pour accéder à une valeur de référence $ACH_{ref}$ sont également envisageables, en particulier la valeur de référence peut être la valeur de renouvellement d'air indiquée dans l'étude thermique déposée avec le permis de construire.

Dans un mode de réalisation avantageux, pour chaque période de temps $D_1$ et $D_2$, il existe un intervalle de temps $\Delta t_1$ ou $\Delta t_2$ pour lequel l'évolution mesurée $(c_{ik}(t))_{k=1\ ou\ 2}$ de la concentration du gaz à l'intérieur du local en fonction du temps est sensiblement linéaire, et on fait converger un modèle diffusif R-C et l'évolution mesurée $(c_{ik}(t))_{k=1\ ou\ 2}$ de la manière suivante : pour chaque période de temps $D_k$ on détermine sur l'intervalle de temps $\Delta t_k$ la pente $a_k$ de la tangente à l'évolution $c_{ik}(t)$, et on détermine la valeur du taux de renouvellement d'air ACH du local à partir des pente $a_k$ et des débits du gaz $\dot{q}_k$ appliqués dans le local.

De préférence, les intervalles de temps $\Delta t_1$ et $\Delta t_2$ sur lesquels on effectue le traitement des mesures présentent une "symétrie", où on entend par "symétrie" des intervalles de temps $\Delta t_1$ et $\Delta t_2$ le fait que les deux intervalles ont, d'une part, une même durée et, d'autre part, un point de départ situé à une même distance temporelle du début de la période $D_1$ ou $D_2$ (notamment, x minutes après le début de chaque période $D_1$ ou $D_2$).

Telle que décrite précédemment, l'invention propose d'imposer des débits du gaz $\dot{q}_k$ distincts dans le local sur au moins deux périodes de temps $D_k$ successives et de mesurer pour chaque période de temps $D_k$ l'évolution temporelle de la concentration du gaz à l'intérieur du local $c_{ik}(t)$.

En variante, il est également possible d'imposer des concentrations du gaz $c_{ik}$ distinctes à l'intérieur du local sur au moins deux périodes de temps $D_k$ successives et de mesurer pour chaque période de temps $D_k$ l'évolution temporelle du débit du gaz à l'intérieur du local $\dot{q}_k(t)$.

Selon cette variante, l'invention a pour objet un procédé de détermination du taux de renouvellement d'air $ACH$ d'un local, caractérisé en ce qu'il comprend des étapes dans lesquelles :

- sur au moins deux périodes de temps $D_k$ successives correspondant à des concentrations d'un gaz donné $c_{ik}$ distinctes appliquées dans le local, on procède à une campagne de mesures du débit du gaz à l'intérieur du local $\dot{q}_k$ à intervalles de temps rapprochés, ainsi qu'à la détermination de la concentration du gaz à l'extérieur du local $c_{ek}$ à intervalles de temps rapprochés ;
- on détermine la valeur du taux de renouvellement d'air $ACH$ du local en faisant converger :

d'une part, un modèle diffusif exprimant la variation temporelle du débit du gaz à l'intérieur du local $\dot{q}_k$ en fonction de la concentration du gaz à l'extérieur du local $c_{ek}$ et de paramètres physiques du local à partir desquels le taux de renouvellement d'air $ACH$ du local est calculable,

et

d'autre part, l'évolution mesurée $\dot{q}_k(t)$ du débit du gaz à l'intérieur du local $\dot{q}_k$ en fonction du temps.

De préférence, le procédé est mis en œuvre avec deux périodes de temps $D_1$ et $D_2$ successives correspondant à deux consignes de concentration du gaz $c_{i1}$ et $c_{i2}$ distinctes appliquées dans le local.

Dans un mode de réalisation, au moins une partie des étapes du procédé de détermination du taux de renouvellement d'air $ACH$ du local sont déterminées par des instructions de programmes d'ordinateurs.

En conséquence, l'invention a également pour objet un programme d'ordinateur sur un support d'enregistrement, ce programme étant susceptible d'être mis en œuvre dans un terminal, ou plus généralement dans un ordinateur, ce programme comportant des instructions adaptées à la mise en œuvre de tout ou partie des étapes d'un procédé tel que décrit ci-dessus.

Ce programme peut utiliser n'importe quel langage de programmation, et être sous la forme de code source, code objet, ou de code intermédiaire entre code source et code objet, tel que dans une forme partiellement compilée.

L'invention a aussi pour objet un support d'enregistrement lisible par un ordinateur, et comportant des instructions d'un programme d'ordinateur tel que mentionné ci-dessus.

Le support d'enregistrement peut être n'importe quelle entité ou dispositif capable de stocker le programme. Par exemple, le support peut comporter un moyen de stockage, tel qu'une mémoire morte, une mémoire non volatile réinscriptible, par exemple une clé USB, une carte SD, une EEPROM, ou encore un moyen d'enregistrement magnétique, par exemple un disque dur.

Le support d'enregistrement peut aussi être un circuit intégré dans lequel le programme est incorporé, le circuit étant adapté pour exécuter ou pour être utilisé dans l'exécution du procédé.

Le support d'enregistrement peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Un autre objet de l'invention est un dispositif de détermination du taux de renouvellement d'air $ACH$ d'un local, ce dispositif comprenant :

- au moins un appareil configuré pour appliquer, sur au moins deux périodes de temps $D_k$ successives, des débits distincts d'un gaz donné $\dot{q}_k$ dans le local ;
- au moins un capteur configuré pour mesurer une concentration du gaz à l'intérieur du local $c_{ik}$ à intervalles de temps rapprochés ;
- un terminal comportant un module de traitement configuré pour faire converger, d'une part, un modèle diffusif exprimant la variation temporelle de la concentration du gaz à l'intérieur du local $c_{ik}$ en fonction de la concentration du gaz à l'extérieur du local $c_{ek}$ et de paramètres physiques du local à partir desquels le taux de renouvellement d'air $ACH$ du local est calculable et, d'autre part, l'évolution mesurée $c_{ik}(t)$ de la concentration du gaz à l'intérieur du local $c_{ik}$ en fonction du temps, de manière à obtenir la valeur du taux de renouvellement d'air du local.

Chaque débit du gaz $\dot{q}_k$ appliqué dans le local sur une période de temps $D_k$ à l'aide du ou des appareils d'application d'un débit du gaz peut être un débit positif, correspondant à une injection du gaz dans le local, un débit négatif, correspondant à une extraction du gaz hors du local, ou un débit nul.

Selon un aspect de l'invention, lorsque le gaz utilisé est la vapeur d'eau, le dispositif peut comprendre, pour appliquer chaque débit de vapeur d'eau dans le local, un ou plusieurs humidificateurs, notamment de type humidificateur à ultrasons, et pour mesurer la concentration de vapeur d'eau dans l'air à l'intérieur du local, un ou plusieurs capteurs d'humidité destinés à être positionnés dans le volume d'air à l'intérieur du local.

Selon une caractéristique, le dispositif comprend également au moins un capteur configuré pour mesurer une concentration du gaz à l'extérieur du local $c_{ek}$ à intervalles de temps rapprochés.

Selon une autre caractéristique, le dispositif comprend en outre au moins un capteur configuré pour mesurer la température de l'air à l'intérieur du local $T_{ik}$.

L'invention a également pour objet un terminal comportant un module de traitement configuré pour faire converger, d'une part, un modèle diffusif exprimant la variation temporelle de la concentration d'un gaz donné à l'intérieur d'un local $c_{ik}$ en fonction de la concentration du gaz à l'extérieur du local $c_{ek}$ et de paramètres physiques du local à partir desquels le taux de renouvellement d'air $ACH$ du local est calculable et, d'autre part, une évolution mesurée $c_{ik}(t)$ de la concentration du gaz à l'intérieur du local $c_{ik}$ en fonction du temps, de manière à obtenir la valeur du taux de renouvellement d'air du local.

Selon un aspect, le module de traitement du terminal selon l'invention comporte un programme d'ordinateur tel que mentionné ci-dessus, ce programme étant enregistré sur un support d'enregistrement conforme à l'invention et constitué par une mémoire non volatile réinscriptible du terminal, les instructions du programme étant interprétables par un processeur du terminal.

Le terminal, le programme d'ordinateur et le support d'enregistrement présentent, selon l'invention, les mêmes caractéristiques que le procédé selon l'invention. L'invention peut être mise en œuvre avec tout type de terminal, par exemple un ordinateur portable ou non, une tablette, un téléphone intelligent ("smartphone" en anglais).

Dans le cadre de l'invention, le ou chaque capteur de mesure d'une concentration du gaz à l'intérieur du local $c_{ik}$ peut être un capteur indépendant du terminal. En variante, le ou chaque capteur de mesure d'une concentration du gaz à l'intérieur du local $c_{ik}$ peut être un capteur intégré dans le terminal. En particulier, il est possible selon l'invention d'effectuer les mesures à l'aide de capteurs de gaz et éventuellement de capteurs de température qui sont intégrés dans une tablette ou un smartphone, et d'avoir une application installée sur la tablette ou le smartphone pour l'acquisition des mesures et la mise en œuvre des étapes du procédé.

Dans un mode de réalisation, le dispositif selon l'invention comprend des moyens de liaison, notamment sans fil tels que Bluetooth, WiFi, etc., entre le ou chaque capteur de mesure d'une concentration du gaz et le terminal.

De manière avantageuse, le terminal comporte des moyens de commande du ou de chaque appareil d'application d'un débit dudit gaz dans le local.

Les caractéristiques et avantages de l'invention apparaîtront dans la description qui va suivre de deux exemples de mise en œuvre d'un procédé et d'un dispositif selon l'invention, donnée uniquement à titre d'exemple et faite en se référant aux figures annexées dans lesquelles :

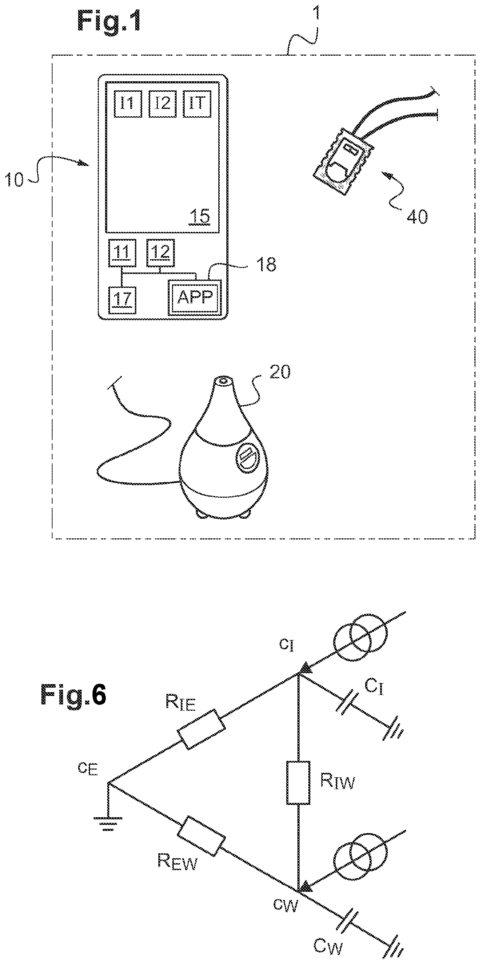

- la figure 1 est une vue schématique d'un local dont on souhaite déterminer le taux de renouvellement d'air *ACH* conformément au procédé de l'invention, en utilisant un dispositif conforme à l'invention comprenant au moins un humidificateur à débit contrôlé pour injecter de la vapeur d'eau dans le local, au moins un capteur d'humidité et un terminal ;

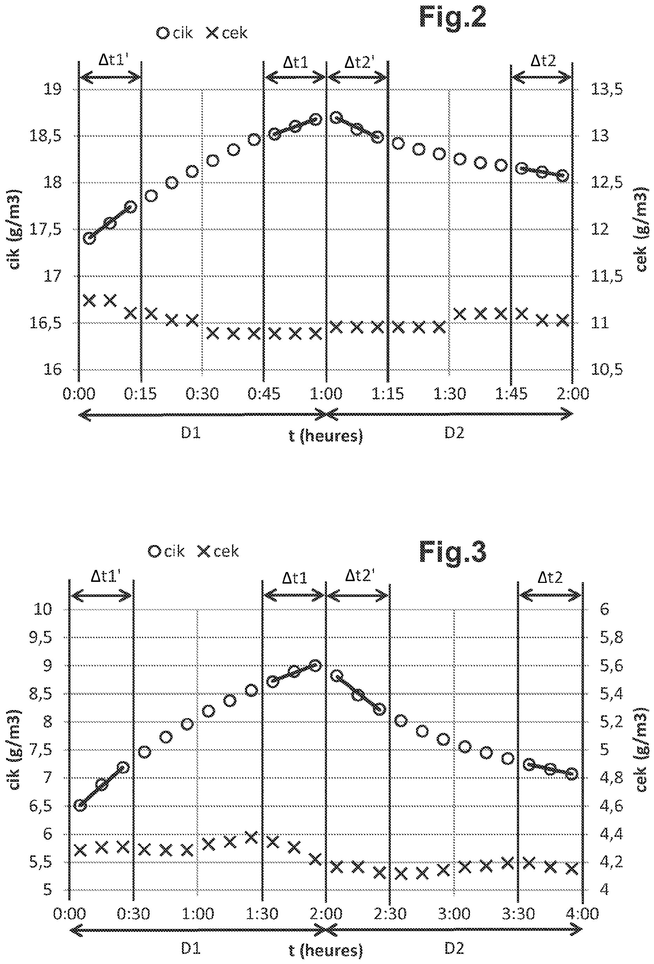

- la figure 2 est un graphe montrant l'évolution de l'humidité absolue $c_{ik}$ à l'intérieur d'un bungalow en fonction du temps, au cours de la mise en œuvre du procédé de l'invention comprenant une première période de temps $D_1$ sur laquelle un premier débit de vapeur d'eau $\dot{q}_1$ positif est appliqué dans le bungalow, suivie d'une deuxième période de temps $D_2$ sur laquelle un deuxième débit de vapeur d'eau $\dot{q}_2$ sensiblement nul est appliqué dans le bungalow de manière à laisser évoluer librement l'humidité absolue $c_{ik}$ à l'intérieur du bungalow, l'évolution de l'humidité absolue $c_{ek}$ à l'extérieur du bungalow en fonction du temps étant également montrée sur cette figure ;
- la figure 3 est un graphe montrant l'évolution de l'humidité absolue $c_{ik}$ à l'intérieur d'un appartement en fonction du temps, au cours de la mise en œuvre du procédé de l'invention comprenant une première période de temps $D_1$ sur laquelle un premier débit de vapeur d'eau $\dot{q}_1$ positif est appliqué dans l'appartement, suivie d'une deuxième période de temps $D_2$ sur laquelle un deuxième débit de vapeur d'eau $\dot{q}_2$ sensiblement nul est appliqué dans l'appartement de manière à laisser évoluer librement l'humidité absolue $c_{ik}$ à l'intérieur de l'appartement, l'évolution de l'humidité absolue $c_{ek}$ à l'extérieur de l'appartement en fonction du temps étant également montrée sur cette figure ;

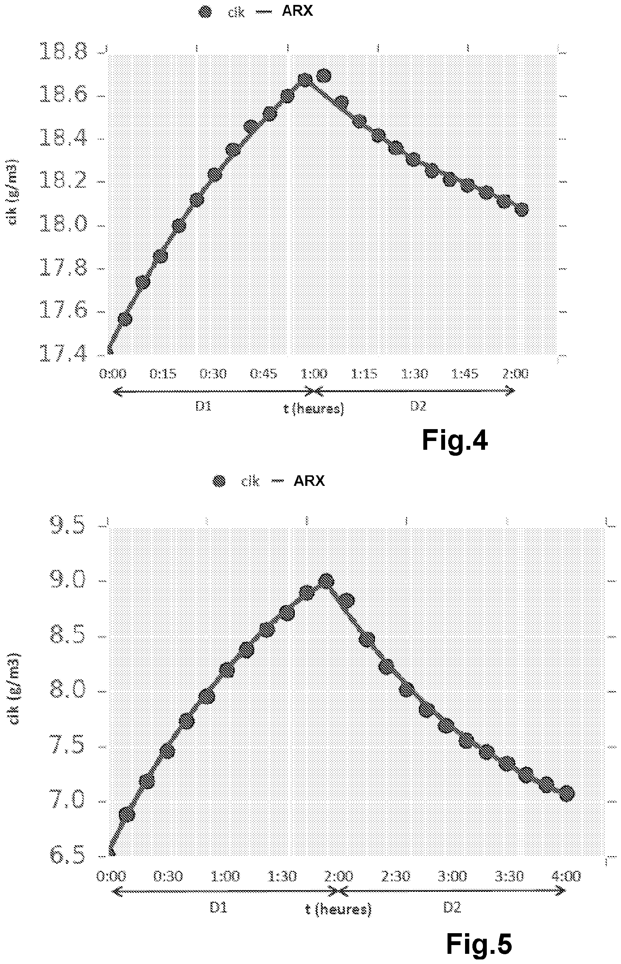

- la figure 4 est un graphe illustrant l'ajustement (fitting) d'un modèle ARX sur l'évolution montrée sur la figure 2 de l'humidité absolue $c_{ik}$ à l'intérieur du bungalow en fonction du temps, obtenu en faisant converger le modèle ARX et l'évolution mesurée $c_{ik}(t)$ de la concentration du gaz sur l'ensemble des deux périodes de temps $D_1$ et $D_2$ ;
- la figure 5 est un graphe illustrant l'ajustement (fitting) d'un modèle ARX sur l'évolution montrée sur la figure 3 de l'humidité absolue $c_{ik}$ à l'intérieur de l'appartement en fonction du temps, obtenu en faisant converger le modèle ARX et l'évolution mesurée $c_{ik}(t)$ de la concentration du gaz sur l'ensemble des deux périodes de temps $D_1$ et $D_2$ ;
- la figure 6 est un schéma d'un modèle dit "3R2C" d'un local, avec trois résistances et deux capacités.

## PROTOCOLE EXPERIMENTAL

Le procédé selon l'invention est mis en œuvre pour la détermination du taux de renouvellement d'air *ACH* d'un bungalow (exemple 1) et d'un appartement (exemple 2), qui constituent chacun un local au sens de l'invention, référencé 1 sur la figure 1. Le protocole expérimental est similaire pour les deux exemples, comme décrit ci-dessous.

Pour chaque exemple, le procédé comprend une première phase d'humidification sur une première période de temps $D_1$, ayant une durée d'une heure pour le bungalow, de minuit à 1:00 du matin, et de deux heures pour l'appartement, de minuit à 2:00 du matin, au cours de laquelle un premier débit de vapeur d'eau $\dot{q}_1$ strictement positif est appliqué dans le local 1, ce qui correspond à une injection de vapeur d'eau dans le local. La première phase est suivie d'une deuxième phase de "déshumidification naturelle" sur une deuxième période de temps $D_2$, ayant une durée d'une heure pour le bungalow, de 1:00 à 2:00 du matin, et de deux heures pour l'appartement, de 2:00 à 4:00 du matin, au cours de laquelle un deuxième débit de vapeur d'eau $\dot{q}_2$ nul est appliqué dans le local 1, donnant lieu à une diminution libre de la concentration de vapeur d'eau à l'intérieur du local. Dans chaque exemple, la phase de déshumidification naturelle a la même durée que la phase d'humidification.

L'application des débits de vapeur d'eau $\dot{q}_1$ et $\dot{q}_2$ dans le local 1 est assurée par le biais d'un ou plusieurs humidificateurs 20 de type "GOTA", commercialisés par la société Air Naturel, placés dans le local. Chaque humidificateur 20 est un humidificateur à ultrasons avec un réservoir de 3 L, pouvant humidifier jusqu'à un taux de 300 g.h$^{-1}$. Chaque

humidificateur 20 est branché sur une prise programmable afin de pouvoir être commuté en ON/OFF de manière automatique. La programmation des prises est effectuée de manière à démarrer le ou chaque humidificateur 20 au début de la première période de temps $D_1$, et à couper le ou chaque humidificateur 20 à la fin de la première période de temps $D_1$. Afin de connaître le débit de vapeur d'eau $\dot{q}_1$ appliqué dans le local au cours de la première période de temps $D_1$, chaque humidificateur 20 est pesé au début et à la fin de la période $D_1$. Connaissant la durée d'allumage de chaque humidificateur 20, il est possible de déterminer le débit moyen de vapeur d'eau appliqué au cours de la période $D_1$.

Au cours des deux périodes de temps $D_1$ et $D_2$, l'évolution de l'humidité et de la température à l'intérieur et à l'extérieur du local 1 est mesurée à l'aide de capteurs 40 d'humidité et de température de type SHT15, commercialisés par la société Sensirion. Pour le bungalow (exemple 1), le nombre de capteurs 40 utilisés est un capteur 40 placé dans l'air à l'intérieur du bungalow et un capteur 40 placé dans l'air à l'extérieur du bungalow. Pour l'appartement (exemple 2), le nombre de capteurs 40 utilisés est cinq capteurs 40 répartis en étant placés dans l'air à l'intérieur de l'appartement et un capteur 40 placé dans l'air à l'extérieur de l'appartement. Le positionnement des capteurs 40 dans le local 1 est ajusté de manière à obtenir une mesure représentative de l'humidité moyenne et de la température moyenne de l'air à l'intérieur du local.

Pour chaque exemple, le procédé est mis en œuvre alors que le local 1 est inoccupé et toutes les sources de production de vapeur d'eau autres que les humidificateurs 20 sont coupées dans le local. Aucune ventilation mécanique ni source de chaleur ou de froid n'est active dans le local 1 au cours du procédé. De plus, dans le cas de l'appartement (exemple 2), toutes les portes de communication internes sont ouvertes. Dans chaque exemple, des ventilateurs domestiques sont installés dans le local 1, afin d'assurer un léger brassage de l'air à l'intérieur du local.

Les données de mesures brutes obtenues dans le local 1 sont ensuite acquises par un système d'acquisition d'un terminal 10, qui les traite en exécutant des instructions d'un programme d'ordinateur PG conforme à l'invention installé dans le terminal 10, de manière à déterminer le taux de renouvellement d'air du local 1.

Comme montré de façon schématique sur la figure 1, le terminal 10 est dans cet exemple constitué par une tablette ou un téléphone intelligent ("smartphone"), offrant à l'utilisateur, au-delà des fonctions de communication, l'accès à diverses applications dès lors que celles-ci ont été installées dans le terminal.

D'un point de vue matériel, le terminal 10 comporte notamment un processeur 11, une mémoire morte de type ROM 12 dans laquelle sont enregistrées des fonctions systèmes, en particulier des pilotes logiciel ("drivers" en anglais) et le système d'exploitation du terminal, un écran 15, un ou plusieurs modules de communication (3G, 4G, Bluetooth, WiFi, ...) 17 et une mémoire non volatile réinscriptible 18 comportant des applications APP et des données utilisateurs non représentées sur la figure, ces éléments étant reliés entre eux par un système de bus.

De façon connue, l'écran 15 constitue une interface homme-machine tactile sur laquelle sont représentées des icônes I1, I2, IT, correspondant aux applications système et aux différentes applications APP installées par l'utilisateur du terminal.

Parmi ces icônes, une icône IT permet au terminal d'accéder à distance, via un réseau de télécommunications, à un portail d'applications téléchargeables compatibles avec le système d'exploitation du terminal et d'installer, éventuellement moyennant paiement et/ou authentification, de nouvelles applications APP dans la mémoire non volatile réinscriptible 18.

Dans le mode de réalisation décrit ici, le programme d'ordinateur PG conforme à l'invention peut être téléchargé à partir de ce portail d'applications, et une icône associée présentée sur l'interface tactile 15.

En particulier, le terminal 10 sur lequel est installé le programme d'ordinateur PG comporte un module de traitement qui est configuré pour mettre en œuvre les étapes suivantes.

- Calcul de l'humidité absolue $c_{ik}$ à l'intérieur du local

L'évolution de l'humidité absolue (ou concentration de vapeur d'eau) $c_{ik}$ à l'intérieur du local 1 est déterminée à partir des humidités relatives et températures mesurées dans le volume intérieur du local. Une moyenne des mesures des différents capteurs 40 répartis dans le local 1 est calculée, pondérée par le volume d'air représentatif de chaque point de mesure. L'humidité absolue $c_{ik}$ à l'intérieur du local 1 est alors déterminée en calculant tout d'abord la pression de vapeur saturante, notamment par l'équation :

$$\ln \frac{P_{ws}}{P_c} = \frac{T_c}{T}\left(C_1\vartheta + C_2\vartheta^{1.5} + C_3\vartheta^3 + C_4\vartheta^{3.5} + C_5\vartheta^4 + C_5\vartheta^4 + C_6\vartheta^{7.5}\right) \quad (3)$$

avec $\vartheta = 1 - \frac{T}{T_c}$, où $T$ est la température en K, $P_{ws}$ la pression de vapeur saturante en hPa, $T_c$ = 647,096 K la température critique, $P_c$ = 220640 hPa la pression critique, et $C_i$ des coefficients sans unité donnés dans le Tableau 1 ci-dessous. Cette relation donne une bonne précision pour des températures allant de 0°C à 373°C. Bien entendu, d'autres équations que l'équation (3) ci-dessus sont également utilisables pour le calcul de l'humidité absolue.

**Tableau 1**

| | |
|---|---|
| $C_1$ | -7,85951783 |
| $C_2$ | 1,84408259 |
| $C_3$ | -11,7866497 |
| $C_4$ | 22,6807411 |
| $C_5$ | -15,9618719 |
| $C_6$ | 1,80122502 |

La pression de vapeur est alors calculée comme étant $P_w = P_{ws}.RH$, où $RH$ est l'humidité relative de l'air, et l'humidité absolue comme étant $c_{ik} = \dfrac{C.P_w}{T}$ où C = 2,16679 g.K/J est une constante.

- Calcul du débit de vapeur d'eau $\dot{q}_1$ au cours de la période $D_1$

Le débit de vapeur d'eau $\dot{q}_1$ appliqué dans le local 1 au cours de la première période de temps $D_1$ est calculé par différence entre la masse totale des humidificateurs 20 au début et à la fin de la période $D_1$ et en connaissant la durée d'injection de vapeur d'eau :

$$\dot{q}_1 = \frac{m_{tot,fin} - m_{tot,début}}{t_{inj}}$$

où $m_{tot,fin}$ et $m_{tot,début}$ sont respectivement les masses totales des humidificateurs dans le local au début et à la fin de la période $D_1$ en grammes et $t_{inj}$ est la durée d'injection de vapeur d'eau en heures.

- Calcul de l'humidité absolue $c_{ek}$ à l'extérieur du local

L'évolution de l'humidité absolue (ou concentration de vapeur d'eau) $c_{ek}$ à l'extérieur du local 1 est déterminée à partir des humidités relatives et températures mesurées à l'extérieur du local, en utilisant la même équation (3) que pour le calcul de l'humidité absolue $c_{ik}$ à l'intérieur du local.

- Calcul du taux de renouvellement d'air $ACH$ et du volume effectif $V$

Le taux de renouvellement d'air $ACH$ et le volume effectif $V$ du local 1 sont calculés en utilisant, respectivement, l'équation (1) et l'équation (2) précédentes.

Dans la description qui suit, on détaille les étapes de calcul du taux de renouvellement d'air $ACH_{calc}$ et du volume effectif $V_{calc}$ de chaque local 1 en faisant référence au graphe de la figure 2 ou au graphe de la figure 3, qui montrent l'évolution de l'humidité absolue $c_{ik}$ à l'intérieur du local en fonction du temps. Ces graphes illustrent les grandeurs intervenant dans les équations (1) et (2), à savoir les pentes $a_1$ et $a_2$ de l'humidité absolue à l'intérieur du local $c_{i1}$ et $c_{i2}$ sur chaque intervalle de temps $\Delta t_1$ ou $\Delta t_2$ sélectionné sur la période $D_1$ ou $D_2$, et les différences d'humidité absolue $\Delta c_{1m}$ et $\Delta c_{2m}$ entre l'intérieur et l'extérieur du local sur chaque intervalle de temps $\Delta t_1$ ou $\Delta t_2$.

Même si les étapes de calcul détaillées ci-après peuvent être effectuées manuellement, elles sont de préférence effectuées de manière automatisée par un terminal tel que le terminal 10 décrit précédemment qui peut, en particulier, ne pas recourir à une représentation graphique de l'évolution $c_{ik}(t)$.

Le terminal requiert auprès de l'utilisateur des données d'entrée, qui peuvent être le volume du local, les débits du gaz $\dot{q}_1$, $\dot{q}_2$ appliqués sur les périodes $D_1$, $D_2$ (ou, en variante, la valeur du paramètre $\alpha$ et une valeur de référence du taux de renouvellement d'air $ACH_{ref}$).

Le terminal fournit en sortie les valeurs calculées du taux de renouvellement d'air $ACH_{calc}$ et du volume effectif $V_{calc}$ du local, ainsi que d'éventuels autres paramètres tels que ceux indiqués dans les tableaux 2 et 3 ci-dessous.

Dans le cadre de l'invention, il peut être intéressant de stocker les données de mesures obtenues dans le local. Ces données peuvent par exemple être utilisées comme un historique dans le cadre d'une rénovation. De plus, ces données peuvent être réutilisées pour optimiser les valeurs calculées du taux de renouvellement d'air $ACH_{calc}$ et du volume effectif $V_{calc}$ du local, en modifiant des paramètres du traitement pour un même set de mesures, comme illustré par les étapes de correction dans les exemples ci-dessous. Le stockage des données de mesures peut être réalisé dans la mémoire d'un terminal utilisé pour la mise en œuvre de l'invention ou dans une mémoire externe de tout type adapté à cette fonction de stockage.

## EXEMPLE 1 : BUNGALOW

La figure 2 montre les résultats obtenus en mettant en œuvre le procédé dans un bungalow ayant une surface au sol de 13 m$^2$, un volume de 33 m$^3$ et une surface totale d'enveloppe de 70 m$^2$. La paroi externe du bungalow est constituée de panneaux sandwich isolants comprenant une couche de polyuréthane d'épaisseur 4 cm insérée entre deux plaques de métal, d'une porte et de deux fenêtres triple vitrage.

Une isolation supplémentaire a été ajoutée à l'enveloppe, qui comprend les matériaux suivants :

- des membranes de type STOPVAP, commercialisées par la société Saint-Gobain Isover,
- des panneaux VIP (Vacuum Insulated Panels) de type va-Q-vip F, commercialisés par la société va-Q-tec, qui recouvrent les murs ;
- 3 cm de polystyrène expansé pour le sol et le plafond, le sol étant aussi recouvert d'un panneau de bois à lamelles minces orientées (OSB).

L'enveloppe du bungalow présente un coefficient de transmission thermique $U_{BAT}$ d'environ 0,6 W/m$^2$K.

Le coefficient $n_{50}$ du bungalow, obtenu par un test de porte soufflante, est de 8,6 h$^{-1}$. En utilisant le modèle de Persily-Kronvall, cela correspond à une valeur de référence du taux de renouvellement d'air $ACH_{ref}$ = 15 m$^3$.h$^{-1}$.

Dans la phase d'humidification du bungalow, sur la première période de temps $D_1$ de minuit à 1:00 du matin, on applique à l'aide des humidificateurs 20 présents dans le bungalow le premier débit de vapeur d'eau $\dot{q}_1$ strictement

positif, qui est choisi tel que le paramètre $\alpha$ = 1 - $\dfrac{ACH_{ref}.\Delta c_1(0)}{\dot{q}_1}$ est égal à 0,46. Dans cet exemple, la valeur de référence $ACH_{ref}$ est de 15 m$^3$.h$^{-1}$ et la différence d'humidité absolue initiale $\Delta c_1(0)$ est de 6,4 g.m$^{-3}$, ce qui correspond à une valeur du premier débit de vapeur d'eau $\dot{q}_1$ de l'ordre de 180 g.h$^{-1}$.

La courbe représentative de l'évolution de l'humidité absolue $c_{i1}$ à l'intérieur du bungalow en fonction du temps pendant la première période de temps $D_1$ est montrée sur la figure 2. Comme visible sur cette figure, la courbe d'augmentation de l'humidité absolue à l'intérieur du bungalow présente une partie sensiblement linéaire sur l'intervalle de temps $\Delta t_1$ de 0:45 à 1:00 du matin. La mise en équation de cette partie linéaire de la courbe donne : $c_{i1}$ = 17,8 g.m$^{-3}$ + 0,00630 t, avec t en secondes.

La figure 2 fait également apparaître l'évolution de l'humidité absolue $c_{e1}$ à l'extérieur du bungalow en fonction du temps pendant la première période de temps $D_1$. L'humidité absolue $c_{e1}$ à l'extérieur du bungalow sur l'intervalle de temps $\Delta t_1$ est suffisamment stable pour qu'on puisse la considérer sensiblement constante et égale à l'humidité absolue moyenne sur l'intervalle de temps $\Delta t_1$, à savoir dans cet exemple $c_{e1m}$ = 11,0 g.m$^{-3}$.

Dans la phase de "déshumidification naturelle" du bungalow, sur la deuxième période de temps $D_2$ de 1:00 à 2:00 du matin, les humidificateurs 20 présents dans le bungalow sont éteints de manière à appliquer le deuxième débit de vapeur d'eau $\dot{q}_2$ nul.

La figure 2 montre la courbe représentative de l'évolution de l'humidité absolue $c_{i2}$ à l'intérieur du bungalow en fonction du temps pendant la deuxième période de temps $D_2$. Comme visible sur cette figure, la courbe de diminution de l'humidité absolue à l'intérieur du bungalow présente une partie sensiblement linéaire sur l'intervalle de temps $\Delta t_2$ de 1:45 à 2:00 du matin. L'intervalle de temps $\Delta t_2$ de traitement des mesures sur la deuxième période $D_2$ est choisi de manière à présenter une "symétrie" avec l'intervalle de temps $\Delta t_1$ de traitement des mesures sur la première période $D_1$, c'est-à-dire de sorte que les deux intervalles de temps $\Delta t_1$ et $\Delta t_2$ ont, d'une part, une même durée de 15 minutes et, d'autre part, un point de départ situé, pour chaque intervalle $\Delta t_k$, 45 minutes après le début de la période $D_k$. La mise en équation de la partie linéaire de la courbe sur l'intervalle de temps $\Delta t_2$ donne : $c_{i2}$ = 19 g.m$^{-3}$ - 0,00311 t, avec t en secondes.

L'évolution de l'humidité absolue $c_{e2}$ à l'extérieur du bungalow en fonction du temps pendant la deuxième période de temps $D_2$ est également montrée sur la figure 2. Comme dans la première étape, l'humidité absolue $c_{e2}$ à l'extérieur du bungalow sur l'intervalle de temps $\Delta t_2$ est suffisamment stable pour qu'on puisse la considérer sensiblement constante et égale à l'humidité absolue moyenne sur l'intervalle de temps $\Delta t_2$, à savoir dans cet exemple $c_{e2m}$ = 11,0 g.m$^{-3}$.

Comme $ACH = \frac{a_1 \times \dot{q}_2 - a_2 \times \dot{q}_1}{a_1 \times \Delta c_{2m} - a_2 \times \Delta c_{1m}}$ d'après l'équation (1) précédente, en prenant $a_1$ = 22,7 g.m$^{-3}$.h$^{-1}$, $a_2$ = - 11,2 g.m$^{-3}$.h$^{-1}$, $\Delta c_{1m}$ = 7,7 g.m$^{-3}$, $\Delta c_{2m}$ = 7,0 g.m$^{-3}$, $\dot{q}_1$ = 180 g.h$^{-1}$, $\dot{q}_2$ = 0 g.h$^{-1}$, on obtient la valeur du taux de renouvellement d'air $ACH$ du bungalow :

$$ACH_{calc} = 8{,}2 \ \text{m}^3.\text{h}^{-1}.$$

Cette valeur $ACH_{calc}$ du taux renouvellement d'air obtenue selon l'invention présente un écart significatif par rapport à l'estimation issue du test de porte soufflante $ACH_{ref}$ = 15 m$^3$.h$^{-1}$, mais l'ordre de grandeur reste cohérent. En effet, pendant la mesure de type "porte soufflante", le renouvellement d'air se produit grâce à un forçage à différence de pression très importante, qui n'est pas rencontré de manière naturelle, et il faut utiliser un modèle d'extrapolation à basse pression, ici le modèle de Persily-Kronvall, pour remonter au paramètre physique réaliste.

Comme $V = \frac{\dot{q}_1 \times \Delta c_{2m} - \dot{q}_2 \times \Delta c_{1m}}{a_1 \times \Delta c_{2m} - a_2 \times \Delta c_{1m}}$ d'après l'équation (2) précédente, on obtient également la valeur du volume effectif du bungalow :

$$V_{calc} = 122{,}9 \ \text{m}^3.$$

On peut observer que le volume effectif déterminé $V_{calc}$ = 122,9 m$^3$ est bien supérieur au volume intérieur réel du bungalow $V_{réel}$ = 33 m$^3$. Comme expliqué précédemment, cela peut être lié à l'absorption de la vapeur d'eau par les matériaux présents dans le bungalow et au fait qu'une durée trop longue a été appliquée pour le traitement des mesures.
Lorsqu'on obtient une telle valeur trop élevée du volume effectif $V_{calc}$, l'invention propose de procéder à une correction a posteriori de la valeur calculée $ACH_{calc}$ du taux de renouvellement d'air, en réduisant la durée appliquée pour le traitement des mesures. En pratique, on procède à cette correction en déplaçant les intervalles de temps $\Delta t_1$ et $\Delta t_2$ dans chaque période de temps $D_1$ et $D_2$, tout en conservant la "symétrie" des intervalles de temps $\Delta t_1$ et $\Delta t_2$ telle que définie précédemment, c'est-à-dire en choisissant pour les deux intervalles de temps $\Delta t_1$ et $\Delta t_2$, d'une part, une même durée et, d'autre part, un point de départ situé à une même distance temporelle du début de la période $D_1$ ou $D_2$ (notamment, x minutes après le début de chaque période $D_1$ ou $D_2$), jusqu'à obtenir une valeur du volume effectif $V_{calc}$ sensiblement égale au volume intérieur réel.
Avec une telle démarche, on obtient pour le bungalow des intervalles de temps "corrigés" $\Delta t_1$' de minuit à 0:15 du matin et $\Delta t_2$' de 1:00 à 1:15 du matin tels que montrés sur la figure 2, qui correspondent à une durée réduite pour le traitement des mesures, ce qui donne les résultats corrigés suivants :

$$ACH_{calc}' = 9{,}6 \ \text{m}^3.\text{h}^{-1} \ ;$$

$$V_{calc}' = 56{,}6 \ \text{m}^3.$$

Dans le cas du bungalow, le volume effectif corrigé $V_{calc}$' = 56,6 m$^3$ est toujours supérieur au volume intérieur réel du bungalow $V_{réel}$ = 33 m$^3$. Cela est dû au fait que les revêtements intérieurs du bungalow ne sont pas finalisés, ce qui conduit à une absorption très rapide de la vapeur d'eau par les matériaux de construction du bungalow. Pour un tel bungalow, il serait préférable de mettre en œuvre l'invention avec un autre gaz que la vapeur d'eau pour gagner en précision sur la valeur du volume effectif et du taux de renouvellement d'air.
Il ressort des résultats corrigés précédents que le renouvellement d'air dans le bungalow est d'environ 0,29 volume par heure, ce qui est insuffisant pour assurer une bonne qualité de l'air intérieur.
La perte thermique du bungalow liée à l'infiltration est telle que $K_{inf} = \rho\text{-}C_p.V.ACH$, où $p$ est la masse volumique de l'air sec à 20°C et $C_p$ est la chaleur spécifique de l'air sec à 20°C. A partir de la valeur du taux de renouvellement d'air $ACH_{calc}'$ = 9,6 m$^3$.h$^{-1}$, on obtient donc une valeur de la perte thermique liée à l'infiltration $K_{inf}$ = 3,3 W.K$^{-1}$.
Une évaluation du coefficient de déperdition thermique totale du bungalow a aussi été réalisée, qui fournit une valeur $K_{tot}$ = 29 W.K$^{-1}$. Ainsi, la perte thermique du bungalow liée à l'infiltration représente environ 11% de la perte thermique totale du bungalow, pour un bilan annuel de l'ordre de 13 kWh.m$^{-2}$.an$^{-1}$.
Les données d'infiltration et de déperdition thermique pour le bungalow sont résumées dans le Tableau 2 ci-

dessous.

| | $V$ (m³) | $ACH_{calc}$ (m³.h⁻¹) | $V_{calc}$ (m³) | $ACH$ (h⁻¹) | $K$ (W.K⁻¹) | $E/S_{sol}$ (kWh.m⁻².an⁻¹) |
|---|---|---|---|---|---|---|
| **Renouvellement d'air - Procédé de l'invention** | | 9,6 | 56,6 | 0,29 | 3,3 | 13 |
| **Renouvellement d'air - Porte soufflante** | 33 | 15 | | 0,43 | 4,9 | 20 |
| **Déperdition thermique** | | | | | 29 | 118 |

**Tableau 2 (bungalow)**

### EXEMPLE 2 : APPARTEMENT

La figure 3 montre les résultats obtenus en mettant en œuvre le procédé dans un appartement situé dans une copropriété ancienne (année de construction : 1879) situé à Levallois-Perret, France. L'appartement n'est pas isolé, il est équipé de doubles vitrages récents mais présente une mauvaise étanchéité à l'air. La surface au sol est de 54 m², le volume intérieur de 151 m³, et l'appartement possède deux faces déperditives d'environ 47 m².

L'enveloppe de l'appartement présente un coefficient de transmission thermique $U_{BAT}$ d'environ 1,9 W/m²K.

Le coefficient $n_{50}$ de l'appartement, obtenu par un test de porte soufflante, est de 7,3 h⁻¹. En utilisant le modèle de Persily-Kronvall, cela correspond à une valeur de référence du taux de renouvellement d'air $ACH_{ref}$ = 55 m³.h⁻¹.

Dans la phase d'humidification de l'appartement, sur la première période de temps $D_1$ de minuit à 2:00 du matin, on applique à l'aide des humidificateurs 20 répartis dans l'appartement le premier débit de vapeur d'eau $\dot{q}_1$ strictement positif, qui est choisi tel que le paramètre $\alpha = 1 - \dfrac{ACH_{ref}.\Delta c_1(0)}{\dot{q}_1}$ est égal à 0,78. Dans cet exemple, la valeur de référence $ACH_{ref}$ est de 55 m³.h⁻¹ et la différence d'humidité absolue initiale $\Delta c_1(0)$ est de 2,2 g.m⁻³, ce qui correspond à une valeur du premier débit de vapeur d'eau $\dot{q}_1$ de l'ordre de 550 g.h⁻¹.

La courbe représentative de l'évolution de l'humidité absolue $c_{i1}$ à l'intérieur de l'appartement en fonction du temps pendant la première période de temps $D_1$ est montrée sur la figure 3. Comme visible sur cette figure, la courbe d'augmentation de l'humidité absolue à l'intérieur de l'appartement présente une partie sensiblement linéaire sur l'intervalle de temps $\Delta t_1$ de 1:30 à 2:00 du matin. La mise en équation de cette partie linéaire de la courbe donne : $c_{i1}$ = 7,4 g.m⁻³ + 0,00578 t, avec t en secondes.

La figure 3 fait également apparaître l'évolution de l'humidité absolue $c_{e1}$ à l'extérieur de l'appartement en fonction du temps pendant la première période de temps $D_1$. L'humidité absolue $c_{e1}$ à l'extérieur de l'appartement sur l'intervalle de temps $\Delta t_1$ est suffisamment stable pour qu'on puisse la considérer sensiblement constante et égale à l'humidité absolue moyenne sur l'intervalle de temps $\Delta t_1$, à savoir dans cet exemple $c_{e1m}$ = 4,3 g.m⁻³.

Dans la phase de "déshumidification naturelle" de l'appartement, sur la deuxième période de temps $D_2$ de 2:00 à 4:00 du matin, les humidificateurs 20 présents dans l'appartement sont éteints de manière à appliquer le deuxième débit de vapeur d'eau $\dot{q}_2$ nul.

La figure 3 montre la courbe représentative de l'évolution de l'humidité absolue $c_{i2}$ à l'intérieur de l'appartement en fonction du temps pendant la deuxième période de temps $D_2$. Comme visible sur cette figure, la courbe de diminution de l'humidité absolue à l'intérieur de l'appartement présente une partie sensiblement linéaire sur l'intervalle de temps $\Delta t_2$ de 3:30 à 4:00 du matin. Comme pour l'exemple précédent, l'intervalle de temps $\Delta t_2$ de traitement des mesures sur la deuxième période $D_2$ est choisi de manière à présenter une "symétrie" avec l'intervalle de temps $\Delta t_1$ de traitement des mesures sur la première période $D_1$, c'est-à-dire de sorte que les deux intervalles de temps $\Delta t_1$ et $\Delta t_2$ ont, d'une part, une même durée de 30 minutes et, d'autre part, un point de départ situé, pour chaque intervalle $\Delta t_k$, 1h30 après

le début de la période $D_k$. La mise en équation de la partie linéaire de la courbe sur l'intervalle de temps $\Delta t_2$ donne : $c_{i2}$ = 9,0 g.m$^{-3}$ - 0,00334 t, avec t en secondes.

L'évolution de l'humidité absolue $c_{e2}$ à l'extérieur de l'appartement en fonction du temps pendant la deuxième période de temps $D_2$ est également montrée sur la figure 3. Comme dans la première étape, l'humidité absolue $c_{e2}$ à l'extérieur de l'appartement sur l'intervalle de temps $\Delta t_2$ est suffisamment stable pour qu'on puisse la considérer sensiblement constante et égale à l'humidité absolue moyenne sur l'intervalle de temps $\Delta t_2$, à savoir dans cet exemple $c_{e2m}$ = 4,2 g.m$^{-3}$.

Comme $ACH = \dfrac{a_1 \times \dot{q}_2 - a_2 \times \dot{q}_1}{a_1 \times \Delta c_{2m} - a_2 \times \Delta c_{1m}}$ d'après l'équation (1) précédente, en prenant $a_1$ = 20,8 g.m$^{-3}$.h$^{-1}$, $a_2$ = - 12,0 g.m$^{-3}$.h$^{-1}$, $\Delta c_{1m}$ = 4,8 g.m$^{-3}$, $\Delta c_{2m}$= 2,9 g.m$^{-3}$, $\dot{q}_1$ = 550 g.h$^{-1}$, $\dot{q}_2$ = 0 g.h$^{-1}$, on obtient la valeur du taux de renouvellement d'air $ACH$ de l'appartement :

$$ACH_{calc} = 56,1 \text{ m}^3.\text{h}^{-1}.$$

Cette valeur $ACH_{calc}$ du taux renouvellement d'air obtenue selon l'invention est en accord avec l'estimation issue du test de porte soufflante $ACH_{ref}$ = 55 M$^3$.h$^{-1}$.

Comme $V = \dfrac{\dot{q}_1 \times \Delta c_{2m} - \dot{q}_2 \times \Delta c_{1m}}{a_1 \times \Delta c_{2m} - a_2 \times \Delta c_{1m}}$ d'après l'équation (2) précédente, on obtient également la valeur du volume effectif de l'appartement :

$$V_{calc} = 321,7 \text{ m}^3.$$

On peut observer que le volume effectif déterminé $V_{calc}$ = 321,7 m$^3$ est bien supérieur au volume intérieur réel de l'appartement $V_{réel}$ = 151 m$^3$, ce qui peut être lié à l'absorption de la vapeur d'eau par les matériaux présents dans l'appartement et au fait qu'une durée trop longue a été appliquée pour le traitement des mesures.

Comme dans l'exemple du bungalow, on peut alors procéder à une correction a posteriori de la valeur calculée $ACH_{calc}$ du taux de renouvellement d'air de l'appartement, en déplaçant les intervalles de temps $\Delta t_1$ et $\Delta t_2$ dans chaque période de temps $D_1$ et $D_2$, tout en conservant la "symétrie" de ces intervalles de temps $\Delta t_1$ et $\Delta t_2$, de manière à réduire la durée de traitement des mesures, jusqu'à obtenir une valeur du volume effectif $V_{calc}$ sensiblement égale au volume intérieur réel de l'appartement.

Avec une telle démarche, on obtient pour l'appartement des intervalles de temps "corrigés" $\Delta t_1$' de minuit à 0:30 du matin et $\Delta t_2$' de 2:00 à 2:30 du matin tels que montrés sur la figure 3, qui correspondent à une durée réduite pour le traitement des mesures, ce qui donne les résultats corrigés suivants :

$$ACH_{calc}' = 73,3 \text{ m}^3.\text{h}^{-1} \; ;$$

$$V_{calc}' = 159,1 \text{ m}^3.$$

La valeur corrigée du volume effectif $V_{calc}$' = 159,1 m$^3$ est en bon accord avec le volume intérieur réel de l'appartement $V_{réel}$ = 151 m$^3$, ce qui tend à montrer que la valeur corrigée du taux de renouvellement d'air $ACH_{calc}$' = 73,3 m$^3$.h$^{-1}$ est une meilleure estimation que la première valeur $ACH_{calc}$ = 56,1 m$^3$.h$^{-1}$.

Il ressort des résultats ci-dessus que le renouvellement d'air dans l'appartement est d'environ 0,48 volume par heure, ce qui est presque suffisant pour assurer une bonne qualité de l'air intérieur.

La perte thermique de l'appartement liée à l'infiltration est telle que $K_{inf} = p. \; C_p. \; V.ACH$, où $\rho$ est la masse volumique de l'air et $C_p$ est la chaleur spécifique de l'air sec à 20°C. A partir de la valeur du taux de renouvellement d'air $ACH_{calc}$ = 73,3 m$^3$.h$^{-1}$, on obtient donc une valeur de la perte thermique liée à l'infiltration $K_{inf}$ = 24,4 W.K$^{-1}$.

Une évaluation du coefficient de déperdition thermique totale de l'appartement a aussi été réalisée, qui fournit une valeur $K_{tot}$ = 81 W.K$^{-1}$. Ainsi, la perte thermique de l'appartement liée à l'infiltration représente environ 30% de la perte thermique totale de l'appartement, pour un bilan annuel de l'ordre de 25 kWh.m$^{-2}$.an$^{-1}$.

Les données d'infiltration et de déperdition thermique pour l'appartement sont résumées dans le Tableau 3 ci-dessous.

| | $V$ (m³) | $ACH_{calc}$ (m³.h⁻¹) | $V_{calc}$ (m³) | $ACH$ (h⁻¹) | $K$ (W.K⁻¹) | $E/S_{sol}$ (kWh.m⁻².an⁻¹) |
|---|---|---|---|---|---|---|
| Renouvellement d'air - Procédé de l'invention | | 73,3 | 159,1 | 0,48 | 24,4 | 25 |
| Renouvellement d'air - Porte soufflante | 151 | 55 | | 0,36 | 19 | 19 |
| Déperdition thermique | | | | | 81 | 83 |

**Tableau 3 (appartement)**

De manière avantageuse, dans les exemples précédents, les étapes de sélection des intervalles de temps $\Delta t_k$ pour le traitement des données, de linéarisation, et de calcul du taux de renouvellement d'air $ACH$ et du volume effectif $V$ du local, sont réalisées au moyen d'un terminal tel que le terminal 10 décrit précédemment comportant le programme PG.

Selon un autre exemple de réalisation, les données de mesures obtenues dans le cadre des exemples 1 et 2 ont été traitées avec un modèle ARX, au lieu d'un modèle R-C simple comme précédemment. On a ainsi procédé, pour chaque local parmi le bungalow et l'appartement, à l'ajustement (fitting) d'un modèle ARX sur l'évolution de l'humidité absolue $c_{ik}$ à l'intérieur du local en fonction du temps, sur l'ensemble des deux périodes de temps $D_1$ et $D_2$, comme illustré sur la figure 4 pour le bungalow et sur la figure 5 pour l'appartement, et à l'obtention du taux de renouvellement d'air $ACH$ du local à partir des coefficients $a_i$, $b_i$, $d_j$ du modèle ARX.

La valeur du taux de renouvellement d'air $ACH$ obtenue en faisant converger un modèle ARX d'ordre 1 et l'évolution mesurée $c_{ik}(t)$ est :

- pour le bungalow : $ACH_{ARX}$ = 7,84 $\pm$ 0,89 m³.h⁻¹,
- pour l'appartement : $ACH_{ARX}$ = 64,8 $\pm$ 2,7 m³.h⁻¹,

ce qui est bien cohérent avec les résultats des tableaux précédents en termes d'ordres de grandeur. On note que l'ordre du modèle ARX correspond au nombre de constantes de temps du modèle diffusif. Un modèle ARX d'ordre 1 est ainsi équivalent à un modèle R-C simple avec une résistance et une capacité. En pratique, un modèle ARX d'ordre strictement supérieur à 1 aurait également pu être utilisé pour traiter les données des exemples 1 et 2, mais il est apparu que l'ordre 1 fournit de bons résultats, tout en évitant un sur-paramétrage.

Comme illustré dans les exemples précédents, le procédé de l'invention propose de réaliser des sollicitations du local en au moins deux phases ayant des débits différents du gaz (qui dans les exemples est la vapeur d'eau). Cette expérience dynamique en au moins deux phases permet de réduire le temps de mesure, tout en conservant une bonne précision sur le résultat.

Des applications du procédé et du dispositif selon l'invention comprennent, notamment :

- la prescription lors de la rénovation de logements anciens, en permettant d'évaluer la quantité d'énergie perdue à cause des infiltrations naturelles et ainsi de prescrire une solution adaptée pour améliorer l'enveloppe du local ;
- la validation de la perméabilité de l'enveloppe à réception d'un bâtiment neuf ;
- l'évaluation du taux de renouvellement d'air créé par une ventilation mécanique, afin de vérifier que le débit est suffisant pour assurer une bonne qualité de l'air intérieur.

L'invention n'est pas limitée aux exemples décrits et représentés.

En particulier, le procédé selon l'invention peut être mis en œuvre avec tout gaz adapté autre que la vapeur d'eau, notamment $CO_2$, He, $SF_6$, $H_2$, $N_2$, ou d'autres gaz traceurs réfrigérants.

De plus, sur au moins une période de temps $D_k$, le débit du gaz appliqué dans le local peut être négatif au lieu d'être positif, correspondant à une extraction du gaz hors du local au lieu d'une injection du gaz dans le local.

Par ailleurs, dans les exemples précédents, la méthode de traitement des données correspond au cas où le modèle diffusif utilisé est un modèle R-C simple avec une résistance et une capacité, ou un modèle ARX d'ordre 1. En variante, les données de l'évolution de la concentration du gaz à l'intérieur du local $c_{ik}$ en fonction du temps peuvent être traitées différemment, par exemple avec un modèle R-C autre qu'un modèle R-C simple, tel qu'un modèle "3R2C" du local avec trois résistances et deux capacités ; ou avec un modèle ARX d'ordre n strictement supérieur à 1 ou tout autre modèle d'identification paramétrique adapté ; ou encore avec un modèle récursif sous forme discrète en temps avec une période d'échantillonnage donnée décrivant le comportement en régime transitoire du local.

La figure 6 montre un schéma d'un modèle "3R2C" d'un local avec trois résistances et deux capacités. Dans ce modèle "3R2C", on considère un réseau à trois nœuds, qui sont l'air à l'intérieur du local (I), l'air à l'extérieur du local (E) et les parois du local (W). L'ambiance extérieure est considérée à une concentration du gaz constante imposée $c_E$. Deux nœuds $c_W$ et $c_I$ représentent schématiquement la concentration du gaz dans les parois et dans l'air intérieur, qui ont chacun une inertie $C_W$, $C_I$ associée représentant la capacité de stockage du gaz dans les parois et dans l'air intérieur. La résistance $R_{EW}$, placée entre l'ambiance extérieure et le nœud des parois, et la résistance $R_{IW}$, placée entre l'ambiance intérieure et le nœud des parois, représentent la résistance à la diffusion du gaz à travers les parois. La troisième résistance $R_{IE}$, placée entre l'ambiance intérieure et l'ambiance extérieure, représente la résistance à la diffusion du gaz par infiltrations. Le taux de renouvellement d'air *ACH* du local est alors l'inverse de la résistance $R_{IE}$.

La résistance totale $R_T$ est telle que :

$$R_T = \frac{R_{IE}(R_{IW} + R_{EW})}{R_{IE} + R_{IW} + R_{EW}}.$$

En pratique, la résistance $R_{IE}$ est très inférieure à la somme des résistances $R_{EW}$ et $R_{IW}$ car le transfert du gaz via les infiltrations est très rapide, alors que la diffusion à travers des parois opaques est un processus lent, ce qui explique que le modèle R-C simple est une bonne approximation.

Selon une variante, il est également possible, dans le cadre de l'invention, d'effectuer les mesures à l'aide de capteurs de gaz (notamment d'humidité) et de capteurs de température qui sont intégrés dans le terminal utilisé pour l'acquisition des mesures et la mise en œuvre des étapes de traitement des données. De manière avantageuse, de tels capteurs d'humidité et de température sont couramment intégrés dans les tablettes et smartphones.

Selon une autre variante, le terminal peut également comporter des moyens de commande du ou des appareils d'application d'un débit du gaz dans le local, et communiquer avec ceux-ci par des moyens de liaison sans fil tels que Bluetooth ou WiFi.

## Revendications

1. Procédé de détermination du taux de renouvellement d'air *ACH* d'un local, **caractérisé en ce qu'**il comprend des étapes dans lesquelles :

   - sur au moins deux périodes de temps $D_k$ successives correspondant à des débits d'un gaz donné $\dot{q}_k$ distincts appliqués dans le local, on procède à une campagne de mesures permettant de déterminer la concentration du gaz à l'intérieur du local $c_{ik}$ à intervalles de temps rapprochés, ainsi qu'à la détermination de la concentration du gaz à l'extérieur du local $c_{ek}$ à intervalles de temps rapprochés ;
   - on détermine la valeur du taux de renouvellement d'air *ACH* du local en faisant converger :

     d'une part, un modèle diffusif exprimant la variation temporelle de la concentration du gaz à l'intérieur du local $c_{ik}$ en fonction de la concentration du gaz à l'extérieur du local $c_{ek}$ et de paramètres physiques du local à partir desquels le taux de renouvellement d'air *ACH* du local est calculable,
     et
     d'autre part, l'évolution mesurée $c_{ik}(t)$ de la concentration du gaz à l'intérieur du local $c_{ik}$ en fonction du temps.

2. Procédé selon la revendication 1, **caractérisé en ce qu'**il comprend des étapes dans lesquelles :

   - sur au moins deux périodes de temps $D_k$ successives correspondant à des débits du gaz $\dot{q}_k$ distincts appliqués dans le local, on procède à une campagne de mesures permettant de déterminer la concentration du gaz à l'intérieur du local $c_{ik}$ à intervalles de temps rapprochés, ainsi qu'à la détermination de la concentration du gaz à l'extérieur du local $c_{ek}$ à intervalles de temps rapprochés ;
   - pour chaque période de temps $D_k$, à partir de l'évolution mesurée $c_{ik}(t)$ de la concentration du gaz à l'intérieur

du local $c_{ik}$ en fonction du temps :

o soit, s'il existe un intervalle de temps $\Delta t_k$ pour lequel l'évolution $c_{ik}(t)$ est sensiblement linéaire, on détermine sur cet intervalle de temps $\Delta t_k$ la pente $a_k$ de la tangente à l'évolution $c_{ik}(t)$ et on déduit la valeur du taux de renouvellement d'air ACH du local à partir des pentes $a_k$ ;

o soit, s'il n'existe pas d'intervalle de temps pour lequel l'évolution $c_{ik}(t)$ est sensiblement linéaire, on sélectionne un intervalle de temps $\Delta t_k'$ sur lequel l'évolution $c_{ik}(t)$ est sensiblement exponentielle de type $\exp(-t/\tau)$, avec $\tau$ le temps au bout duquel le volume d'air intérieur du local a été renouvelé, et on déduit la valeur du taux de renouvellement d'air *ACH* du local, qui est la valeur telle que l'évolution

$$Ln\left[\left(\theta_k(t) - \frac{\dot{q}_k}{ACH}\right)/\left(\theta_k(0) - \frac{\dot{q}_k}{ACH}\right)\right]$$ est une droite, avec $\theta_k(t) = c_{ik}(t) - c_{ekm}'$ où $c_{ekm}'$ est la moyenne

de la concentration du gaz à l'extérieur du local $c_{ek}$ sur l'intervalle de temps $\Delta t_k'$.

3. Procédé selon l'une quelconque des revendications précédentes, **caractérisé en ce qu'**il est mis en œuvre avec deux périodes de temps $D_1$ et $D_2$ successives correspondant à deux consignes de débits du gaz $\dot{q}_1$ et $\dot{q}_2$ distinctes appliquées dans le local.

4. Procédé selon l'une quelconque des revendications précédentes, **caractérisé en ce que** le gaz est $H_2O$, $CO_2$, He, $SF_6$, $H_2$, $N_2$, ou un gaz réfrigérant.

5. Procédé selon l'une quelconque des revendications précédentes, **caractérisé en ce que**, pour chaque période de temps $D_k$, le débit du gaz $\dot{q}_k$ appliqué dans le local comprend un débit $\dot{q}_{impk}$ imposé au moyen d'au moins un appareil (20) à débit contrôlé.

6. Procédé selon l'une quelconque des revendications précédentes, **caractérisé en ce que** les mesures permettant de déterminer la concentration du gaz à l'intérieur du local $c_{ik}$ sont effectuées à l'aide d'un ou de plusieurs capteurs (40) dudit gaz placés dans le volume intérieur du local.

7. Procédé selon l'une quelconque des revendications précédentes, **caractérisé en ce que**, sur chaque période de temps $D_k$, la température à l'intérieur du local $T_{ik}$ est stable.

8. Procédé selon l'une quelconque des revendications précédentes, **caractérisé en ce que**, sur chaque période de temps $D_k$, la concentration du gaz à l'extérieur du local $c_{ek}$ est stable.

9. Procédé selon l'une quelconque des revendications précédentes, **caractérisé en ce que**, sur chaque période de temps $D_k$, le rayonnement solaire est faible, de préférence nul.

10. Procédé selon l'une quelconque des revendications précédentes, **caractérisé en ce que** le procédé est mis en œuvre alors que le local est inoccupé.

11. Procédé selon l'une quelconque des revendications précédentes, **caractérisé en ce qu'**on vérifie que la valeur $V_{calc}$ du volume effectif du local calculée à partir du modèle diffusif et de l'évolution mesurée $c_{ik}(t)$ correspond au volume réel du local, notamment à 20% près.

12. Procédé selon l'une quelconque des revendications précédentes, **caractérisé en ce qu'**il comprend des étapes dans lesquelles :

- on procède, sur deux périodes de temps $D_1$ et $D_2$ successives :

i. sur la première période de temps $D_1$, à l'application dans le local d'un premier débit du gaz $\dot{q}_1$, et à une campagne de mesures permettant de déterminer la concentration du gaz à l'intérieur du local $c_{i1}$ à intervalles de temps rapprochés, ainsi qu'à la détermination de la concentration du gaz à l'extérieur du local $c_{e1}$ à intervalles de temps rapprochés, le premier débit du gaz $\dot{q}_1$ étant tel que le paramètre $\alpha =$

$$1 - \frac{ACH_{ref}.\Delta c_1(0)}{\dot{q}_1}$$ est inférieur ou égal à 0,8, avec $\Delta c_1(0) = c_{i1}(0) - c_{em}$, où $t = 0$ est le point de départ de la première période de temps $D_1$, $c_{em}$ est la concentration moyenne du gaz à l'extérieur du local sur l'ensemble des périodes de temps $D_1$ et $D_2$, et $ACH_{ref}$ est une valeur de référence du taux de renouvellement d'air du local, puis

ii. sur la deuxième période de temps $D_2$, à l'application dans le local d'un deuxième débit du gaz $\dot{q}_2$ sensiblement nul, et à une campagne de mesures permettant de déterminer la concentration du gaz à l'intérieur du local $c_{i2}$ à intervalles de temps rapprochés, ainsi qu'à la détermination de la concentration du gaz à l'extérieur du local $c_{e2}$ à intervalles de temps rapprochés ;

- on détermine la valeur du taux de renouvellement d'air $ACH$ du local en faisant converger :

d'une part, un modèle diffusif exprimant la variation temporelle de la concentration du gaz à l'intérieur du local $c_{ik}$ en fonction de la concentration du gaz à l'extérieur du local $c_{ek}$ et de paramètres physiques du local à partir desquels le taux de renouvellement d'air $ACH$ du local est calculable,
et
d'autre part, l'évolution mesurée $c_{ik}(t)$ de la concentration du gaz à l'intérieur du local $c_{ik}$ en fonction du temps.

13. Procédé selon l'une quelconque des revendications 1 à 12, **caractérisé en ce que** le modèle diffusif est un modèle R-C.

14. Procédé selon l'une quelconque des revendications 1 à 12, **caractérisé en ce que** le modèle diffusif est un modèle d'identification paramétrique, notamment un modèle ARX.

15. Programme d'ordinateur comportant des instructions pour l'exécution des étapes d'un procédé selon l'une quelconque des revendications 1 à 14 lorsque ledit programme est exécuté par un ordinateur.

16. Support d'enregistrement lisible par un ordinateur sur lequel est enregistré un programme d'ordinateur comprenant des instructions pour l'exécution des étapes d'un procédé selon l'une quelconque des revendications 1 à 14

17. Terminal (10) comportant un module de traitement, **caractérisé en ce que** ledit module de traitement est configuré pour faire converger, d'une part, un module diffusif exprimant la variation temporelle de la concentration d'un gaz donné à l'intérieur d'un local clA. en fonction de la concentration du gaz a l'extérieur du local et de paramètres physiques du local à partir desquels le taux de renouvellement d'air ACH du local est calculable et. d'autre part, une évolution mesurée clA.(t) de la concentration du gaz a l'intérieur du local clk en fonction du temps, de manière à obtenir la valeur du taux de renouvellement d'air du local.

18. Terminal (10) selon la revendication 17, **caractérisé en ce que** le module de traitement comporte un programme d'ordinateur selon la revendication 15, ledit programme étant enregistré sur un support d'enregistrement selon la revendication 16 constitué par une mémoire non volatile réinscriptible (18) du terminal, les instructions dudit programme étant interprétables par un processeur (11) du terminal.

19. Dispositif de détermination du taux de renouvellement d'air $ACH$ d'un local, ce dispositif étant **caractérisé en ce qu'**il comprend :

- au moins un appareil (20) configuré pour appliquer, sur au moins deux périodes de temps $D_k$ successives, des débits d'un gaz donné $\dot{q}_k$ distincts dans le local ;
- au moins un capteur (40) configuré pour mesurer une concentration du gaz à l'intérieur du local $c_{ik}$ à intervalles de temps rapprochés ;
- un terminal (10) selon l'une des revendications 17 et 18.

20. Dispositif selon la revendication 19, **caractérisé en ce qu'**il comprend en outre au moins un capteur (40) configuré pour mesurer une concentration du gaz à l'extérieur du local $c_{ek}$ à intervalles de temps rapprochés.

21. Dispositif selon l'une quelconque des revendication 19 ou 20, **caractérisé en ce qu'**il comprend en outre au moins un capteur de température configuré pour mesurer la température à l'intérieur du local $T_{ik}$.

22. Dispositif selon l'une quelconque des revendications 19 à 21, **caractérisé en ce qu'**il comprend des moyens de liaison, notamment sans fil, entre le ou chaque capteur (40) de mesure d'une concentration du gaz et le terminal (10).

**23.** Dispositif selon l'une quelconque des revendications 19 à 22 **caractérisé en ce que** le terminal (10) comporte des moyens de commande de l'appareil (20) configuré pour appliquer un débit du gaz.

**Patentansprüche**

1. Verfahren zur Bestimmung der Luftänderungsrate *ACH* eines Raumes, **dadurch gekennzeichnet, dass** es folgende Schritte umfasst:

   - über mindestens zwei aufeinander folgende Zeiträume $D_k$, die unterschiedlichen Durchflussmengen eines gegebenen Gases $\dot{q}_k$ entsprechen, die im Raum angewendet werden, wird eine Messreihe, die das Bestimmen einer Gaskonzentration innerhalb des Raumes $c_{ik}$ in kurzen Zeitabständen ermöglicht, sowie die Bestimmung der Gaskonzentration außerhalb des Raumes $c_{ek}$ in kurzen Zeitabständen durchgeführt;
   - es wird der Wert der Luftänderungsrate *ACH* des Raumes durch Konvergieren des Folgenden bestimmt:

   einerseits eines Diffusionsmodells, das die zeitliche Variation der Gaskonzentration innerhalb des Raumes $c_{ik}$ in Abhängigkeit von der Gaskonzentration außerhalb des Raumes $c_{ek}$ und von physikalischen Parameters des Raumes angibt, auf deren Basis die Luftänderungsrate *ACH* des Raumes berechnet werden kann, und
   andererseits der gemessenen Entwicklung $c_{ik}(t)$ der Gaskonzentration innerhalb des Raumes $c_{ik}$ in Abhängigkeit von der Zeit.

2. Verfahren nach Anspruch 1, **dadurch gekennzeichnet, dass** es folgende Schritte umfasst:

   - über mindestens zwei aufeinanderfolgende Zeiträume $D_k$, die unterschiedlichen Gasdurchflussmengen $\dot{q}_k$ entsprechen, die im Raum angewendet werden, wird eine Messreihe, die das Bestimmen einer Gaskonzentration innerhalb des Raumes $c_{ik}$ in kurzen Zeitabständen ermöglicht, sowie die Bestimmung der Gaskonzentration außerhalb des Raumes $c_{ek}$ in kurzen Zeitabständen durchgeführt;
   - für jeden Zeitraum $D_k$, basierend auf der gemessenen Entwicklung $c_{ik}(t)$ der Gaskonzentration innerhalb des Raumes $c_{ik}$ in Abhängigkeit von der Zeit:

   o entweder, falls es einen Zeitabstand $\Delta t_k$ gibt, für den die Entwicklung $c_{ik}(t)$ im Wesentlichen linear ist, wird über diesen Zeitabstand $\Delta t_k$, der Steigung $a_k$ der Tangente mit der Entwicklung $c_{ik}(t)$ bestimmt und es wird der Wert der Luftänderungsrate *ACH* des Raumes basierend auf den Steigungen $a_k$ abgeleitet;
   o oder, falls es keinen Zeitabstand gibt, für den die Entwicklung $c_{ik}(t)$ im Wesentlichen linear ist, wird ein Zeitabstand $\Delta t_k'$ ausgewählt, über den die Entwicklung $c_{ik}(t)$ im Wesentlichen exponentiell vom Typ $exp(-t/\tau)$ ist, wobei $\tau$ die Zeit ist, nach der das Luftvolumen innerhalb des Raumes geändert wurde, und es wird der Wert der Luftänderungsrate *ACH* des Raumes abgeleitet, wobei der Wert so ist, dass die Entwicklung

   $$Ln\left[(\theta_k(t) - \frac{\dot{q}_k}{ACH})/(\theta_k(0) - \frac{\dot{q}_k}{ACH})\right]$$ eine Gerade ist, wobei $\theta_k(t) = c_{ik}(t) - c_{ekm}'$, wobei $c_{ekm}'$ der Mittelwert der Gaskonzentration außerhalb des Raumes $c_{ek}$ über den Zeitabstand $\Delta t_k'$ ist.

3. Verfahren nach einem der vorstehenden Ansprüche, **dadurch gekennzeichnet, dass** es mit zwei aufeinander folgenden Zeiträumen $D_1$ und $D_2$ durchgeführt wird, die zwei unterschiedlichen Gasdurchflussmengensollwerten $\dot{q}_1$ und $\dot{q}_2$ entsprechen, die im Raum angewendet werden.

4. Verfahren nach einem der vorstehenden Ansprüche, **dadurch gekennzeichnet, dass** das Gas $H_2O$, $CO_2$, He, $SF_6$, $H_2$, $N_2$ oder ein Kühlgas ist.

5. Verfahren nach einem der vorstehenden Ansprüche, **dadurch gekennzeichnet, dass** für jeden Zeitraum $D_k$ die im Raum angewendete Gasdurchflussmenge $\dot{q}_k$ eine Durchflussmenge $\dot{q}_{impk}$ umfasst, die mittels mindestens eines Geräts (20) mit Durchflussregelung durchgesetzt wird.

6. Verfahren nach einem der vorstehenden Ansprüche, **dadurch gekennzeichnet, dass** die Messungen, die das Bestimmen der Gaskonzentration innerhalb des Raumes $c_{ik}$ ermöglichen, mit Hilfe eines oder mehrerer Sensoren (40) des Gases vorgenommen werden, die im Innenvolumen des Raumes platziert sind.

7. Verfahren nach einem der vorstehenden Ansprüche, **dadurch gekennzeichnet, dass** über jeden Zeitraum $D_k$ die Temperatur innerhalb des Raumes $T_{ik}$ stabil ist.

8. Verfahren nach einem der vorstehenden Ansprüche, **dadurch gekennzeichnet, dass** über jeden Zeitraum $D_k$ die Gaskonzentration außerhalb des Raumes $c_{ek}$ stabil ist.

9. Verfahren nach einem der vorstehenden Ansprüche, **dadurch gekennzeichnet, dass** über jeden Zeitraum $D_k$ die Sonneneinstrahlung gering, vorzugsweise Null ist.

10. Verfahren nach einem der vorstehenden Ansprüche, **dadurch gekennzeichnet, dass** das Verfahren durchgeführt wird, während der Raum leer ist.

11. Verfahren nach einem der vorstehenden Ansprüche, **dadurch gekennzeichnet, dass** überprüft wird, dass der Wert $V_{calc}$ des effektiven Raumvolumens, der basierend auf dem Diffusionsmodell und der gemessenen Entwicklung $c_{ik}(t)$ berechnet wird, dem realen Raumvolumen, insbesondere bis auf 20 %, entspricht.

12. Verfahren nach einem der vorstehenden Ansprüche, **dadurch gekennzeichnet, dass** es folgende Schritte umfasst:

- es wird über zwei aufeinander folgende Zeiträume $D_1$ und $D_2$ Folgendes durchgeführt:

i. über den ersten Zeitraum $D_1$, die Anwendung einer ersten Gasdurchflussmenge $\dot{q}_1$ im Raum und eine Messreihe, die das Bestimmen der Gaskonzentration innerhalb des Raumes $c_{i1}$ in kurzen Zeitabständen ermöglicht, sowie die Bestimmung der Gaskonzentration außerhalb des Raumes $c_{e1}$ in kurzen Zeitabständen, wobei die erste Gasdurchflussmenge $\dot{q}_1$ so ist, dass der Parameter $\alpha = 1 - \frac{ACH_{ref}.\Delta c_1(0)}{\dot{q}_1}$ $\alpha$ niedriger als oder gleich 0,8 ist, wobei $\Delta c_1(0) = c_{i1}(0) - c_{em}$, wobei $t = 0$ der Ausgangspunkt des ersten Zeitraums $D_1$ ist, $c_{em}$ die mittlere Gaskonzentration außerhalb des Raumes über alle Zeiträume $D_1$ und $D_2$ ist und $ACH_{ref}$ ein Referenzwert der Luftänderungsrate des Raumes ist, dann

ii. über den zweiten Zeitraum $D_2$, die Anwendung einer zweiten Gasdurchflussmenge $\dot{q}_2$ im Raum, die im Wesentlichen Null ist, und eine Messreihe, die das Bestimmen der Gaskonzentration innerhalb des Raumes $c_{i2}$ in kurzen Zeitabständen ermöglicht, sowie die Bestimmung der Gaskonzentration außerhalb des Raumes $c_{e2}$ in kurzen Zeitabständen;

- es wird der Wert der Luftänderungsrate $ACH$ des Raumes durch Konvergieren des Folgenden bestimmt:

einerseits eines Diffusionsmodells, das die zeitliche Variation der Gaskonzentration innerhalb des Raumes $c_{ik}$ in Abhängigkeit von der Gaskonzentration außerhalb des Raumes $c_{ek}$ und von physikalischen Parametern des Raumes angibt, auf deren Basis die Luftänderungsrate $ACH$ des Raumes berechnet werden kann, und
andererseits der gemessenen Entwicklung $c_{ik}(t)$ der Gaskonzentration innerhalb des Raumes $c_{ik}$ in Abhängigkeit von der Zeit.

13. Verfahren nach einem der Ansprüche 1 bis 12, **dadurch gekennzeichnet, dass** das Diffusionsmodell ein R-C-Modell ist.

14. Verfahren nach einem der Ansprüche 1 bis 12, **dadurch gekennzeichnet, dass** das Diffusionsmodell ein parametrisches Identifikationsmodell, insbesondere ein ARX-Modell ist.

15. Computerprogramm, umfassend Anweisungen zur Durchführung der Schritte eines Verfahrens nach einem der Ansprüche 1 bis 14, wenn das Programm von einem Computer ausgeführt wird.

16. Computerlesbares Speichermedium, auf dem ein Computerprogramm gespeichert ist, das Anweisungen zur Durchführung der Schritte eines Verfahrens nach einem der Ansprüche 1 bis 14 umfasst.

17. Endgerät (10), umfassend ein Verarbeitungsmodul, **dadurch gekennzeichnet, dass** das Verarbeitungsmodul konfiguriert ist zum Konvergieren einerseits eines Diffusionsmodells, das die zeitliche Variation der Konzentration eines gegebenen Gases innerhalb eines Raumes clA. in Abhängigkeit von der Gaskonzentration außerhalb des Raumes und von physikalischen Parametern des Raumes angibt, auf deren Basis die Luftänderungsrate ACH des Raumes berechnet werden kann, und andererseits einer gemessenen Entwicklung clA.(t) der Gaskonzentration innerhalb des Raumes clk in Abhängigkeit von der Zeit, um den Wert der Luftänderungsrate des Raumes zu erhalten.

18. Endgerät (10) nach Anspruch 17, **dadurch gekennzeichnet, dass** das Verarbeitungsmodul ein Computerprogramm nach Anspruch 15 umfasst, wobei das Programm auf einem Speichermedium nach Anspruch 16 gespeichert ist, das aus einem wiederbeschreibbaren nichtflüchtigen Speicher (18) des Endgeräts besteht, wobei die Anweisungen des Programms durch einen Prozessor (11) des Endgeräts interpretierbar sind.

19. Vorrichtung zur Bestimmung der Luftänderungsrate *ACH* eines Raumes, wobei die Vorrichtung **dadurch gekennzeichnet ist, dass** sie Folgendes umfasst:

   - mindestens ein Gerät (20), das konfiguriert ist, um über mindestens zwei aufeinanderfolgende Zeiträume $D_k$ unterschiedliche Durchflussmengen eines gegebenen Gases $\dot{q}_k$ in dem Raum anzuwenden;
   - mindestens einen Sensor (40), der konfiguriert ist, um eine Gaskonzentration innerhalb des Raumes $c_{ik}$ in kurzen Zeitabständen zu messen;
   - ein Endgerät (10) nach einem der Ansprüche 17 und 18.

20. Vorrichtung nach Anspruch 19, **dadurch gekennzeichnet, dass** sie ferner mindestens einen Sensor (40) umfasst, der konfiguriert ist, um eine Gaskonzentration außerhalb des Raumes $c_{ek}$ in kurzen Zeitabständen zu messen.

21. Vorrichtung nach einem der Ansprüche 19 oder 20, **dadurch gekennzeichnet, dass** sie ferner mindestens einen Temperatursensor umfasst, der konfiguriert ist, um die Temperatur innerhalb des Raumes $T_{ik}$ zu messen.

22. Vorrichtung nach einem der Ansprüche 19 bis 21, **dadurch gekennzeichnet, dass** sie Mittel zur, insbesondere drahtlosen, Verbindung zwischen dem oder jedem Sensor (40) zur Messung einer Gaskonzentration und dem Endgerät (10) umfasst.

23. Vorrichtung nach einem der Ansprüche 19 bis 22, **dadurch gekennzeichnet, dass** das Endgerät (10) Mittel zum Steuern des Geräts (20) umfasst, das zum Anwenden einer Gasdurchflussmenge konfiguriert ist.

**Claims**

1. A method for determining the air change rate *ACH* of a space, **characterized in that** it comprises steps in which:

   - over at least two successive time periods $D_k$ corresponding to distinct given-gas flow rates $\dot{q}_k$ applied in the space, a campaign of measurements is carried out to make it possible to determine the concentration of the gas inside the space $c_{ik}$ at closely-spaced time intervals, and the concentration of the gas outside the space $c_{ek}$ is determined at closely-spaced time intervals;
   - the value of the air change rate *ACH* of the space is determined by causing the convergence of:

      on the one hand, a diffusive model expressing the temporal variation of the concentration of the gas inside the space $c_{ik}$ as a function of the concentration of the gas outside the space $c_{ek}$ and of physical parameters of the space from which parameters the air change rate *ACH* of the space can be calculated, and
      on the other hand, the measured change $c_{ik}(t)$ in the concentration of the gas inside the space $c_{ik}$ as a function of time.

2. The method as claimed in claim 1, **characterized in that** it comprises steps in which:

   - over at least two successive time periods $D_k$ corresponding to distinct gas flow rates $\dot{q}_k$ applied in the space, a campaign of measurements is carried out to make it possible to determine the concentration of the gas inside the space $c_{ik}$ at closely-spaced time intervals, and the concentration of the gas outside the space $c_{ek}$ is determined at closely-spaced time intervals;
   - for each time period $D_k$ starting from the measured change $c_{ik}(t)$ in the concentration of the gas inside the

space $c_{ik}$ as a function of time:

o either, if there is a time interval $\Delta t_k$ for which the change $c_{ik}(t)$ is substantially linear, the gradient $a_k$ of the tangent at the change $c_{ik}(t)$ is determined over this time interval $\Delta t_k$ and the value of the air change rate $ACH$ of the space is deduced from the gradients $a_k$;

o or, if there is no time interval for which the change $c_{ik}(t)$ is substantially linear, a time interval $\Delta t_k'$ in which the change $c_{ik}(t)$ is substantially exponential of the type $\exp(-t/\tau)$ is selected, where $\tau$ is the time at the end of which the volume of air inside the space has been changed, and the value of the air change rate $ACH$ of the space is deduced, this being the value such that the change

$$Ln\left[(\theta_k(t) - \frac{\dot{q}_k}{ACH})/(\theta_k(0) - \frac{\dot{q}_k}{ACH})\right]$$ is a straight line, where $\theta_k(t) = c_{ik}(t) - c_{ekm}'$, where $c_{ekm}'$ is the mean of the concentration of the gas outside the space $c_{ek}$ over the time interval $\Delta t_k'$.

3. The method as claimed in either one of the preceding claims, **characterized in that** it is implemented with two successive time periods $D_1$ and $D_2$ corresponding to two distinct gas flow rate setpoints $\dot{q}_1$ and $\dot{q}_2$ applied in the space.

4. The method as claimed in any one of the preceding claims, **characterized in that** the gas is $H_2O$, $CO_2$, He, $SF_6$, $H_2$, $N_2$ or a refrigerant gas.

5. The method as claimed in any one of the preceding claims, **characterized in that**, for each time period $D_k$, the gas flow rate $\dot{q}_k$ applied in the space comprises a flow rate $\dot{q}_{impk}$ imposed by means of at least one controlled-flow rate apparatus (20).

6. The method as claimed in any one of the preceding claims, **characterized in that** the measurements making it possible to determine the concentration of the gas inside the space $c_{ik}$ are taken using one or more sensors (40) of said gas which are placed in the interior volume of the space.

7. The method as claimed in any one of the preceding claims, **characterized in that**, over each time period $D_k$, the temperature inside the space $T_{ik}$ is stable.

8. The method as claimed in any one of the preceding claims, **characterized in that**, over each time period $D_k$, the concentration of the gas outside the space $c_{ek}$ is stable.

9. The method as claimed in any one of the preceding claims, **characterized in that**, over each time period $D_k$, the solar radiation is low, preferably zero.

10. The method as claimed in any one of the preceding claims, **characterized in that** the method is implemented while the space is unoccupied.

11. The method as claimed in any one of the preceding claims, **characterized in that** it is verified that the value $V_{calc}$ of the effective volume of the space, calculated from the diffusive model and from the measured change $c_{ik}(t)$, corresponds to the actual volume of the space, notably to within 20%.

12. The method as claimed in any one of the preceding claims, **characterized in that** it comprises steps in which:

- the following are performed, over two successive time periods $D_1$ and $D_2$:

i. over the first time period $D_1$, a first gas flow rate $\dot{q}_1$ is applied in the space, and a campaign of measurements is carried out to determine the concentration of the gas inside the space $c_{i1}$ at closely-spaced time intervals, and the concentration of the gas outside the space $c_{e1}$ is determined at closely-spaced time intervals, the

$$\alpha = 1 - \frac{ACH_{ref}\, \Delta c_1(0)}{\dot{q}_1}$$

first gas flow rate $\dot{q}_1$ being such that the parameter is less than or equal to 0.8, with $\Delta c_1(0) = c_{i1}(0) - c_{em}$, where t=0 is the starting point for the first time period $D_1$, $c_{em}$ is the mean concentration of the gas outside the space over all the time periods $D_1$ and $D_2$, and $ACH_{ref}$ is a reference value for the air change rate of the space, then

ii. over the second time period $D_2$, a substantially zero second gas flow rate $\dot{q}_2$ is applied in the space, and a campaign of measurements is carried out to determine the concentration of the gas inside the space $c_{i2}$ at closely-spaced time intervals, and the concentration of the gas outside the space $c_{e2}$ is determined at closely-spaced time intervals;

- the value of the air change rate *ACH* of the space is determined by causing the convergence of:

on the one hand, a diffusive model expressing the temporal variation of the concentration of the gas inside the space $c_{ik}$ as a function of the concentration of the gas outside the space $c_{ek}$ and of physical parameters of the space from which parameters the air change rate *ACH* of the space can be calculated, and
on the other hand, the measured change $c_{ik}(t)$ in the concentration of the gas inside the space $c_{ik}$ as a function of time.

13. The method as claimed in any one of claims 1 to 12, **characterized in that** the diffusive model is an R-C model.

14. The method as claimed in any one of claims 1 to 12, **characterized in that** the diffusive model is a parametric identification model, notably an ARX model.

15. A computer program comprising instructions for executing the steps of a method as claimed in any one of claims 1 to 14 when said program is executed by a computer.

16. A computer-readable recording medium on which is recorded a computer program comprising instructions for executing the steps of a method as claimed in any one of claims 1 to 14.

17. A terminal (10) comprising a processing module configured to cause convergence of on the one hand, a diffusive model expressing the temporal variation of the concentration of a given gas inside a space $c_{ik}$ as a function of the concentration of the gas outside the space $c_{ek}$ and of physical parameters of the space from which parameters the air change rate *ACH* of the space can be calculated, and on the other hand, a measured change $c_{ik}(t)$ in the concentration of the gas inside the space $c_{ik}$ as a function of time, so as to obtain the value of the air change rate of the space.

18. The terminal (10) as claimed in claim 17, **characterized in that** the processing module comprises a computer program as claimed in claim 15, said program being recorded on a recording medium as claimed in claim 16 consisting of a rewritable nonvolatile memory (18) of the terminal, the instructions of said program being interpretable by a processor (11) of the terminal.

19. A device for determining the air change rate *ACH* of a space, this device being **characterized in that** it comprises:

- at least one apparatus (20) configured to apply, over at least two successive time periods $D_k$, distinct given-gas flow rates $\dot{q}_k$ in the space;
- at least one sensor (40) configured to measure a concentration of the gas inside the space $c_{ik}$ at closely-spaced time intervals;
- a terminal (10) as claimed in any one of claims 17 and 18.

20. The device as claimed in claim 19, **characterized in that** it further comprises at least one sensor (40) configured to measure a concentration of the gas outside the space $c_{ek}$ at closely-spaced time intervals.

21. The device as claimed in either one of claims 19 or 20, **characterized in that** it further comprises at least one temperature sensor configured to measure the temperature inside the space $T_{ik}$.

22. The device as claimed in any one of claims 19 to 21, **characterized in that** it comprises means of connection, notably wireless means of connection between the or each gas-concentration measurement sensor (40) and the terminal (10).

23. The device as claimed in any one of claims 19 to 22, **characterized in that** the terminal (10) comprises means of controlling the apparatus (20) configured to apply a gas flow rate.

## Fig.1

## Fig.6

# Fig.2

# Fig.3

**Fig.4**

**Fig.5**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• US 2013030575 A

**Littérature non-brevet citée dans la description**

• **HENRIK MADSEN.** Time Series Analysis. Chapman & Hall, 2008